# EUROPEAN PATENT APPLICATION

(11) **EP 4 585 726 A1**
(43) Date of publication of application: **16.07.2025**
(21) Application number: 22958170.7
(22) Date of filing: 09.09.2022
(51) Int. Cl.: C30B 29/06, C30B 11/02, C30B 28/06

(54) **N-TYPE SILICON BLOCK AND N-TYPE SILICON SUBSTRATE**

(71) Applicant: Kyocera Corporation, Kyoto-shi, Kyoto 612-8501 (JP)
(72) Inventor: MATSUO, Hitoshi, Kyoto-shi, Kyoto 612-8501 (JP); TANABE, Hideyoshi, Kyoto-shi, Kyoto 612-8501 (JP)
(74) Representative: TBK
(86) International application number: PCT/JP2022/033900
(87) International publication number: WO 2024/053092

(57) **Abstract**

An n-type silicon block contains a donor including a group 15 element, an acceptor including a group 13 element, carbon, and oxygen. The n-type silicon block includes a first portion including more carbon atoms than oxygen atoms per unit volume. The n-type silicon block includes more atoms of the donor than atoms of the acceptor per unit volume. The donor has a greater segregation coefficient in silicon than the acceptor. An n-type silicon substrate contains a donor including a group 15 element, an acceptor including a group 13 element, carbon, and oxygen. The n-type silicon substrate includes more atoms of the donor than atoms of the acceptor per unit volume, and more carbon atoms than oxygen atoms per unit volume. The donor has a greater segregation coefficient in silicon than the acceptor.

## Description

### TECHNICAL FIELD

The present disclosure relates to an n-type silicon block and an n-type silicon substrate.

### BACKGROUND OF INVENTION

Patent Literature 1 describes a technique for manufacturing a p-type silicon ingot by mono-like casting, and cutting the p-type silicon ingot into p-type silicon blocks and p-type silicon substrates.

### CITATION LIST

### PATENT LITERATURE

Patent Literature 1: WO 2020/017360

### SUMMARY

One or more aspects of the present disclosure are directed to an n-type silicon block and an n-type silicon substrate.

In one aspect, an n-type silicon block contains a donor including a group 15 element, an acceptor including a group 13 element, carbon, and oxygen. The n-type silicon block includes a first portion including more carbon atoms than oxygen atoms per unit volume. The n-type silicon block includes more atoms of the donor than atoms of the acceptor per unit volume. The donor has a greater segregation coefficient in silicon than the acceptor.

In one aspect, an n-type silicon substrate contains a donor including a group 15 element, an acceptor including a group 13 element, carbon, and oxygen. The n-type silicon substrate includes more atoms of the donor than atoms of the acceptor per unit volume, and more carbon atoms than oxygen atoms per unit volume. The donor has a greater segregation coefficient in silicon than the acceptor.

### BRIEF DESCRIPTION OF THE DRAWINGS

FIG. 1 is a schematic imaginary cross-sectional view of an example manufacturing apparatus in a first embodiment.
FIG. 2 is a flowchart of an example manufacturing method for a silicon ingot using the manufacturing apparatus in the first embodiment.
FIG. 3 is a schematic imaginary cross-sectional view of the manufacturing apparatus, with a mold release formed on the inner wall of a mold in a second process.
FIG. 4 is a schematic imaginary cross-sectional view of the manufacturing apparatus, with a seed crystal assembly placed on the bottom of the mold in the second process.
FIG. 5 is a schematic diagram of the seed crystal assembly placed on the bottom of the mold in the second process.
FIG. 6 is a diagram describing Σ values.
FIG. 7 is a schematic diagram illustrating example preparation of seed crystals. FIG. 8 is a schematic diagram illustrating example preparation of seed crystals.
FIG. 9 is a schematic imaginary view of the manufacturing apparatus, with multiple silicon lumps as a raw material placed in a first crucible in the second process.
FIG. 10 is a graph schematically showing the relationship between the position in the height direction of a p-type silicon ingot or an n-type silicon ingot manufactured by mono-like casting and the resistivity at the position in a reference example.
FIG. 11 is a schematic imaginary view of the manufacturing apparatus, with the mold being raised and rotated and a gas being fed and discharged in a third process.
FIG. 12 is a schematic imaginary cross-sectional view of the manufacturing apparatus, with silicon melt resulting from the silicon lumps melted in the first crucible being poured into the mold from the first crucible in a fourth process. FIG. 13 is a schematic imaginary cross-sectional view of the manufacturing apparatus, with the silicon melt solidifying unidirectionally in the mold in a fifth process.
FIG. 14 is a schematic cross-sectional view of the silicon ingot in the first embodiment taken along line XIV-XIV in FIG. 15.
FIG. 15 is a schematic cross-sectional view of the silicon ingot in the first embodiment taken along line XV-XV in FIG. 14.
FIG. 16 is a schematic cross-sectional view of an n-type silicon block according to the first embodiment taken along line XVI-XVI in FIG. 17.
FIG. 17 is a schematic cross-sectional view of the n-type silicon block according to the first embodiment taken along line XVII-XVII in FIG. 16.
FIG. 18 is a graph showing an example relationship between the position in the height direction of a silicon ingot in a specific example and the resistivity at the position.
FIG. 19 is a graph showing an example relationship between the position in the height direction of the silicon ingot in the specific example and the number of atoms of each of phosphorus and gallium per unit volume at the position.
FIG. 20 is a graph showing an example relationship between the position in the height direction of an n-type silicon block in the specific example and the lifetime at the position.
FIG. 21 is a graph showing an example relationship between the position in the height direction of the n-type silicon block in the specific example and the number of atoms of each of carbon and oxygen per unit volume at the position.
FIG. 22 is a graph showing an example relationship between the position in the height direction of the n-type silicon block in the specific example and the etch pit density at the position.
FIG. 23 is a graph showing an example relationship between the position in the height direction of the n-type silicon block in the specific example and the area ratio of dislocation clusters at the position.
FIG. 24 is a schematic front view of an example n-type silicon substrate according to the first embodiment.
FIG. 25 is a schematic plan view of the n-type silicon substrate according to the first embodiment.
FIG. 26 is a schematic diagram of a seed crystal assembly placed on the bottom of the mold in the second process in a second embodiment.
FIG. 27 is a schematic cross-sectional view of an example silicon ingot in the second embodiment taken along line XXVII-XXVII in FIG. 28.
FIG. 28 is a schematic cross-sectional view of the silicon ingot in the second embodiment taken along line XXVIII-XXVIII in FIG. 27.
FIG. 29 is a schematic cross-sectional view of a silicon block according to the second embodiment taken along line XXIX-XXIX in FIG. 30.
FIG. 30 is a schematic cross-sectional view of the silicon block according to the second embodiment taken along line XXX-XXX in FIG. 29.
FIG. 31 is a schematic diagram of a seed crystal assembly placed on the bottom of the mold in the second process in a third embodiment.
FIG. 32 is a schematic cross-sectional view of a silicon ingot in the third embodiment taken along line XXXII-XXXII in FIG. 33.
FIG. 33 is a schematic cross-sectional view of the silicon ingot in the third embodiment taken along line XXXIII-XXXIII in FIG. 32.
FIG. 34 is a schematic cross-sectional view of an example n-type silicon block according to the third embodiment taken along line XXXIV-XXXIV in FIG. 35.
FIG. 35 is a schematic cross-sectional view of the n-type silicon block according to the third embodiment taken along line XXXV-XXXV in FIG. 34.
FIG. 36 is a schematic plan view of an example n-type silicon substrate according to the third embodiment.

### DESCRIPTION OF EMBODIMENTS

Solar cells using polycrystalline silicon substrates have relatively high conversion efficiency and are suited to mass-manufacturing. Silicon is obtained from, for example, silicon oxide abundant on the earth. Polycrystalline silicon substrates are also relatively easy to produce by, for example, slicing p-type silicon blocks cut out from a p-type silicon ingot obtained by casting. Solar cells using polycrystalline silicon substrates thus have a large share of the total solar cell production for many years.

Monocrystalline silicon substrates used in solar cells are expected to have higher conversion efficiency than polycrystalline silicon substrates.

To improve the quality of the p-type silicon blocks and p-type silicon substrates, mono-like casting (also referred to as seed casting) may be used as a casting method to manufacture the p-type silicon ingot. With mono-like casting, crystal grains are grown upward from a seed crystal placed on the bottom of a mold using melted silicon (also referred to as silicon melt). This allows the manufacture of a p-type silicon ingot including a portion of a pseudo-monocrystal (also referred to as a mono-like crystal). The pseudo-monocrystal inherits the crystal direction of the seed crystal and grows unidirectionally. The pseudo-monocrystal is allowed to include, for example, several dislocations or grain boundaries.

Solar cells using p-type silicon substrates cut out from the p-type silicon ingot including the pseudo-monocrystalline portion is expected to achieve higher conversion efficiency than solar cells using polycrystalline silicon substrates.

The quality of an n-type silicon block and an n-type silicon substrate is to be improved.

The inventors of the present disclosure thus have developed a technique for improving the quality of the n-type silicon block and the n-type silicon substrate.

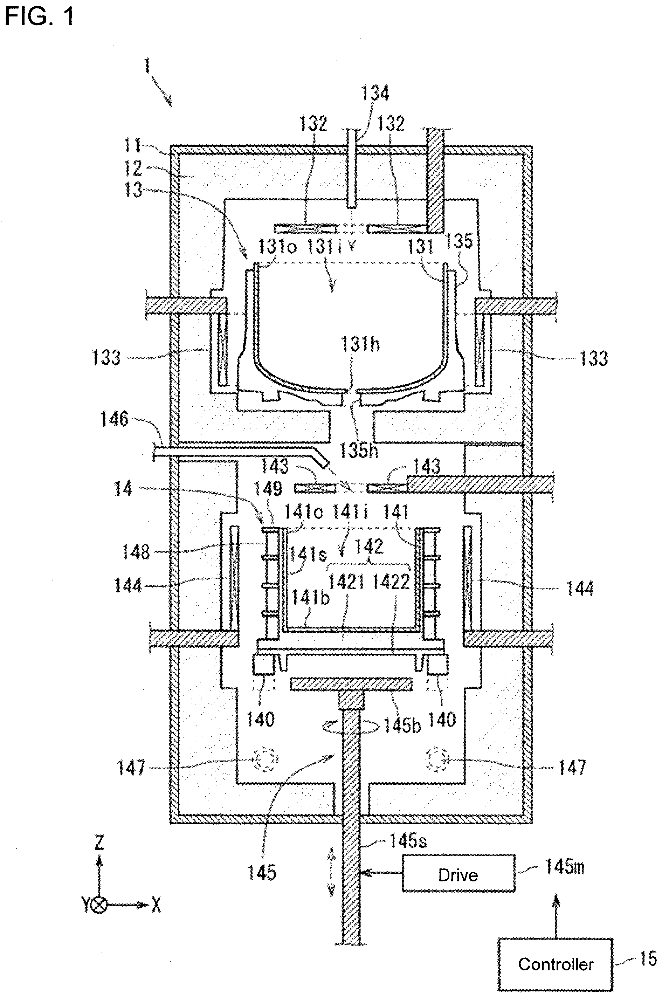

Embodiments of the present disclosure will now be described with reference to the drawings. In the drawings, the same reference numerals denote the components with the same or similar structures and functions, and such components are not described repeatedly. The drawings are schematic. A right-handed XYZ coordinate system is defined in FIGs. 1, 3 to 5, 9, 11 to 17, and 24 to 36. In the XYZ coordinate system, the positive Z-direction as a first direction is parallel to the height of each of a manufacturing apparatus 1, a silicon ingot 2, and an n-type silicon block 3, and to the thickness of an n-type silicon substrate 4. In the XYZ coordinate system, the positive X-direction as a second direction is parallel to the width of each of the manufacturing apparatus 1, the silicon ingot 2, the n-type silicon block 3, and the n-type silicon substrate 4. The positive Y-direction as a third direction is orthogonal to both the positive X-direction and the positive Z-direction. The negative Z-direction as a fourth direction is opposite to the first direction.

### 1. First Embodiment

### 1-1. Manufacturing Apparatus for Silicon Ingot

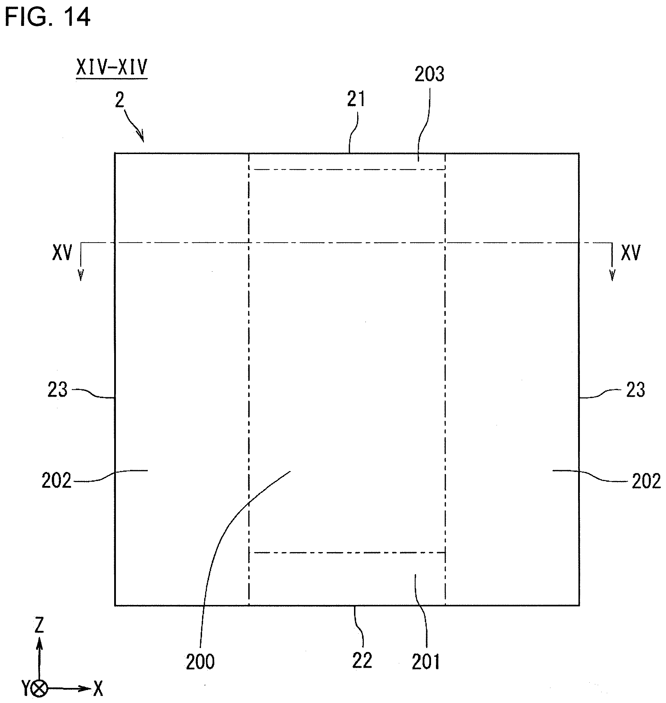

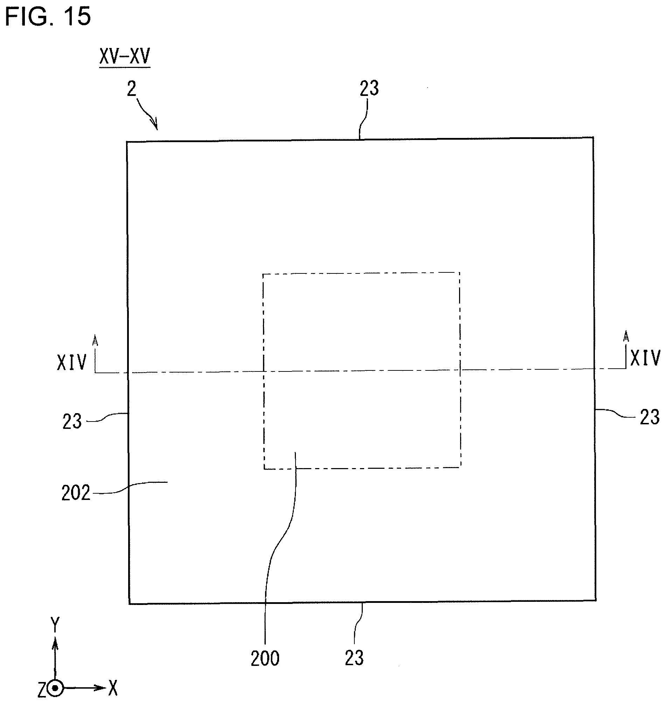

The ingot (also referred to as the silicon ingot) 2 of silicon (refer to FIGs. 14 and 15) in a first embodiment is manufactured with, for example, the manufacturing apparatus 1 operable in a first manner. The manufacturing apparatus 1 is used to manufacture the silicon ingot 2 including a portion of a pseudo-monocrystal (also referred to as a mono-like crystal) by mono-like casting (also referred to as seed casting) for growing crystal grains from a silicon seed crystal. The pseudo-monocrystal may be a monocrystal without dislocations and grain boundaries, may have a structure similar to the structure of a monocrystal with several defects and dislocations, or may have a structure similar to the structure of a monocrystal with several grain boundaries. The monocrystal obtained by mono-like casting is referred to as a pseudo-monocrystal or a mono-like crystal to be distinguished from the monocrystal obtained with a known method such as the Czochralski (CZ) method or the Bridgman method.

The manufacturing apparatus 1 will be described with reference to FIG. 1. With the manufacturing apparatus 1, the silicon ingot 2 is manufactured by solidifying a molten silicon liquid (also referred to as silicon melt) poured from a first crucible 131 into a mold 141 (also referred to as a pouring method). The silicon ingot 2 is a piece of silicon to be a silicon block (also referred to as an n-type silicon block) 3 and a silicon substrate (also referred to as an n-type silicon substrate) 4 that uses free electrons as a main carrier carrying an electric charge.

As illustrated in FIG. 1, the manufacturing apparatus 1 includes, for example, a housing 11, a heat insulating material 12, an upper unit 13, a lower unit 14, and a controller 15.

### Housing 11

The housing 11 accommodates the upper unit 13 and the lower unit 14. The housing 11 includes, for example, a water-cooling jacket. The water-cooling jacket includes a flow passage through which a refrigerant such as water flows in a member of, for example, a metal with high thermal conductivity such as stainless steel. The water-cooling jacket cools the manufacturing apparatus 1 and reduces external radiation of heat generated in the manufacturing apparatus 1.

### Heat Insulating Material 12

The heat insulating material 12 is located in spaces between the housing 11 and the upper unit 13 and between the housing 11 and the lower unit 14. The heat insulating material 12 reduces heat radiation from the upper unit 13 and the lower unit 14. The heat insulating material 12 may be located in a space between the upper unit 13 and the lower unit 14 excluding a passage for silicon melt passing through from the upper unit 13 to the lower unit 14. The heat insulating material 12 may be a carbon material such as carbon fibers.

### Upper Unit 13

The upper unit 13 includes, for example, the first crucible 131, a first heater 132, a second heater 133, and a first gas feeder 134.

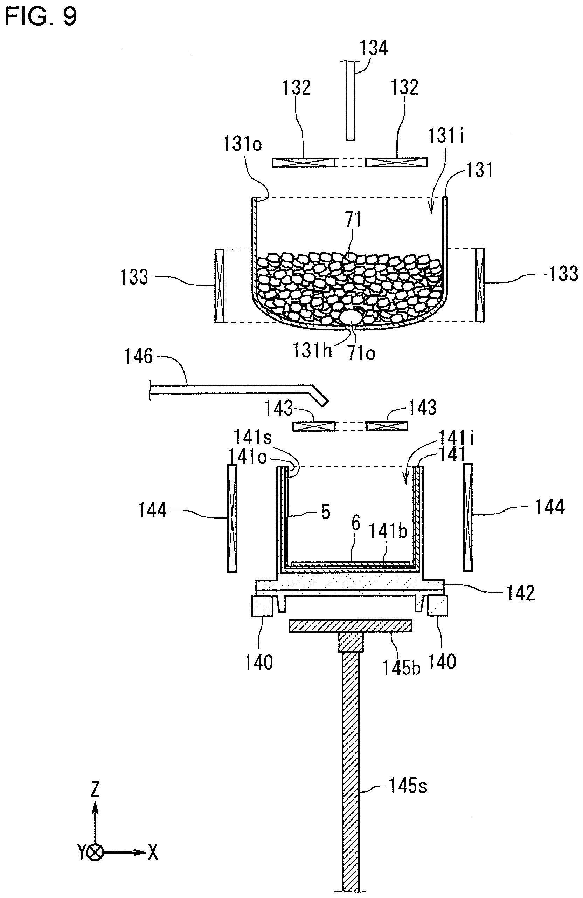

The first crucible 131 is a container for melting silicon lumps 71 as a raw material of the silicon ingot 2 (refer to, for example, FIG. 9). The first crucible 131 has the shape of, for example, a hollow bottomed cylinder. The first crucible 131 defines an internal space (also referred to as a first internal space) 131i. The first crucible 131 includes, for example, an upper opening (also referred to as a first upper opening) 131o and a lower opening (also referred to as a first lower opening) 131h. The first upper opening 131o connects the first internal space 131i with a space above the first crucible 131. The first lower opening 131h extends through the bottom of the first crucible 131. The first lower opening 131h allows the molten silicon (silicon melt) in the first internal space 131i to flow into the lower unit 14. The first crucible 131 is made of, for example, quartz glass. The first crucible 131 may be made of a material other than quartz glass including, for example, a material that is unlikely to melt, deform, decompose, and react with silicon at temperatures equal to or above the melting point of silicon with a low impurity content. The first crucible 131 is fixed to the housing 11 with a heat-resistant member such as a graphite member in between.

The first heater 132 can heat, for example, the silicon lumps 71 in the first internal space 131i from above. The first heater 132 is located above the first internal space 131i. For example, the first heater 132 is looped when viewed in plan in the negative Z-direction.

The second heater 133 can heat, for example, the silicon lumps 71 in the first internal space 131i laterally. The second heater 133 surrounds the first crucible 131 laterally. The second heater 133 is looped and surrounds the first crucible 131 when viewed in plan in the negative Z-direction.

The first heater 132 and the second heater 133 may each be, for example, a graphite heater for resistance heating. One or more of the first heater 132 and the second heater 133 may be, for example, a heater other than a graphite heater for resistance heating. The first heater 132 and the second heater 133 may each generate heat using, for example, power supplied under control by the controller 15. The first heater 132 and the second heater 133 are fixed to the housing 11 with a heat-resistant member such as a graphite member in between.

The first gas feeder 134 can feed an inert gas into the first internal space 131i through the first upper opening 131o. The first gas feeder 134 includes a pipe (also referred to as a first feed pipe) that can blow the inert gas into the first internal space 131i from above. The inert gas may be, for example, an argon (Ar) gas. The inert gas may be a noble gas other than argon or may be a nitrogen gas. In FIG. 1, an imaginary thin two-dot-dash arrow indicates the inert gas blown from the first gas feeder 134 into the first internal space 131i.

The upper unit 13 may include a second crucible 135 located along the outer surface of the first crucible 131. The second crucible 135 has the shape of a hollow bottomed cylinder. The second crucible 135 includes, for example, a lower opening (also referred to as a second lower opening) 135h. The second lower opening 135h extends through the bottom of the second crucible 135. The second lower opening 135h is connected with the first lower opening 131h directly below the first lower opening 131h. In other words, the first lower opening 131h and the second lower opening 135h are aligned downward to define one through-hole. When the second lower opening 135h has a larger inner diameter than the first lower opening 131h, the silicon melt flowing downward from the first internal space 131i through the first lower opening 131h is less likely to come in contact with the inner wall of the second lower opening 135h. The second crucible 135 may be made of, for example, a material with high heat resistance such as graphite. The second crucible 135 may be made of, for example, any material with high heat resistance other than graphite. The second crucible 135 is fixed to, for example, the housing 11 with a heat-resistant member such as a graphite member in between. In this case, the first crucible 131 is fixed to the housing 11 with the second crucible 135 as a first member with heat resistance and a second member with heat resistance in between. For example, one or more rings (also referred to as reinforcing rings) may be located along the outer periphery of the second crucible 135 to reinforce the first crucible 131 and the second crucible 135. The reinforcing rings may be made of, for example, a carbon fiber-reinforced carbon composite (C/C composite).

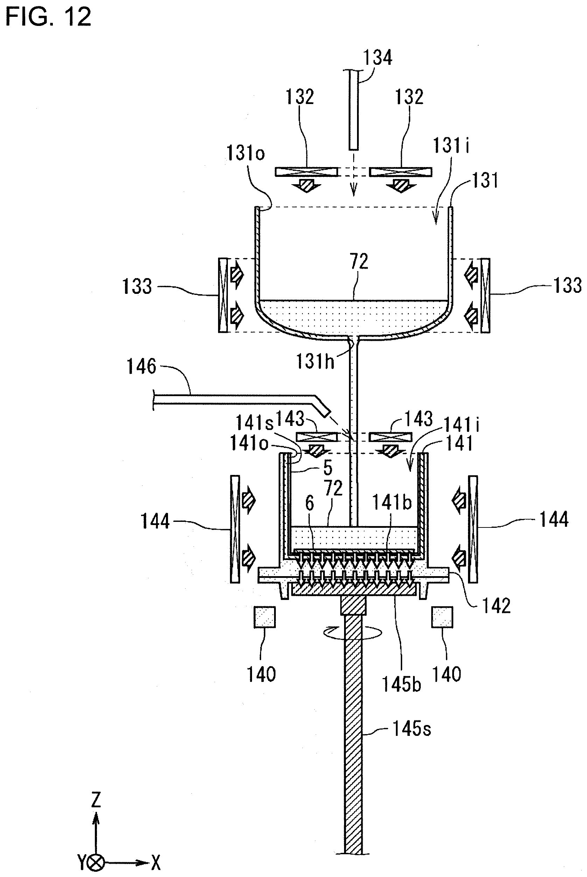

To manufacture the silicon ingot 2 using, for example, the manufacturing apparatus 1, multiple silicon lumps 71 are placed in the first internal space 131i of the first crucible 131 in the upper unit 13. The silicon lumps 71 may contain, for example, silicon in powder form (also referred to as silicon powder). The silicon lumps 71 placed in the first internal space 131i melt when heated with the first heater 132 and the second heater 133. For example, the silicon lumps 71 in the first lower opening 131h melt when heated to cause silicon melt 72 (refer to, for example, FIG. 12) in the first internal space 131i to be poured into the mold 141 in the lower unit 14 through the first lower opening 131h. In some embodiments, the upper unit 13 may not include the first lower opening 131h in the first crucible 131. In this case, the first crucible 131 may be tilted to pour the silicon melt 72 into the mold 141 in the lower unit 14 from the first crucible 131.

### Lower Unit 14

The lower unit 14 includes, for example, the mold 141, a holder 142, a third heater 143, fourth heaters 144, a cooler 145, a second gas feeder 146, and a discharger 147.

The mold 141 is used to obtain the silicon ingot 2 by growing crystal grains upward from a seed crystal of silicon using the silicon melt 72. The mold 141 has the shape of, for example, a hollow bottomed prism. The mold 141 includes, for example, a bottom 141b and a side wall 141s. The bottom 141b is, for example, a rectangular plate when viewed in plan in the negative Z-direction. The side wall 141s is, for example, a hollow prism extending upward from the outer periphery of the bottom 141b. The mold 141 defines an internal space (also referred to as a second internal space) 141i. The mold 141 includes, for example, an upper opening (also referred to as a second upper opening) 141o. The second upper opening 141o connects the second internal space 141i with a space above the mold 141. In other words, the second upper opening 141o is open in the positive Z-direction as the first direction. The second upper opening 141o is, for example, at the end of the mold 141 in the positive Z-direction. Each of the bottom 141b and the second upper opening 141o measures, for example, about 300 to 800 millimeters (mm) on a side. The second upper opening 141o can receive the silicon melt 72 poured into the second internal space 141i from the first crucible 131. The mold 141 is made of, for example, silica. The mold 141 may be made of a material other than silica including, for example, a material that is unlikely to melt, deform, decompose, and react with silicon at temperatures equal to or above the melting point of silicon with a low impurity content.

The holder 142 holds the mold 141. The holder 142 includes, for example, a portion (also referred to as a first holder) 1421 extending along the outer surface of the mold 141 opposite to the second internal space 141i. The first holder 1421 includes, for example, a plate portion (also referred to as a bottom plate) in close contact with the lower surface of the bottom 141b of the mold 141 and a hollow prismatic portion (also referred to as a side portion) extending along the outer peripheral surface of the side wall 141s of the mold 141. The side wall 141s of the mold 141 may be reinforced by the side portion. The first holder 1421 may be made of, for example, a C/C composite. The holder 142 may also include a portion (also referred to as a second holder) 1422 holding the first holder 1421 from below. The second holder 1422 includes, for example, a plate portion (also referred to as a plate) in close contact with the lower surface of the first holder 1421 and a looped portion (also referred to as a looped protrusion) protruding downward from the lower surface of the plate. The second holder 1422 may be made of, for example, a material with high thermal conductivity such as graphite.

A looped heat insulator 148 or a looped reinforcement 149 may surround, for example, the side portion of the first holder 1421. The looped heat insulator 148 may be made of, for example, a graphite heat insulating material. The looped reinforcement 149 may be made of, for example, a C/C composite. A heat insulator may be located between the bottom 141b of the mold 141 and the holder 142 in an intended pattern. The heat insulator may be made of, for example, felt.

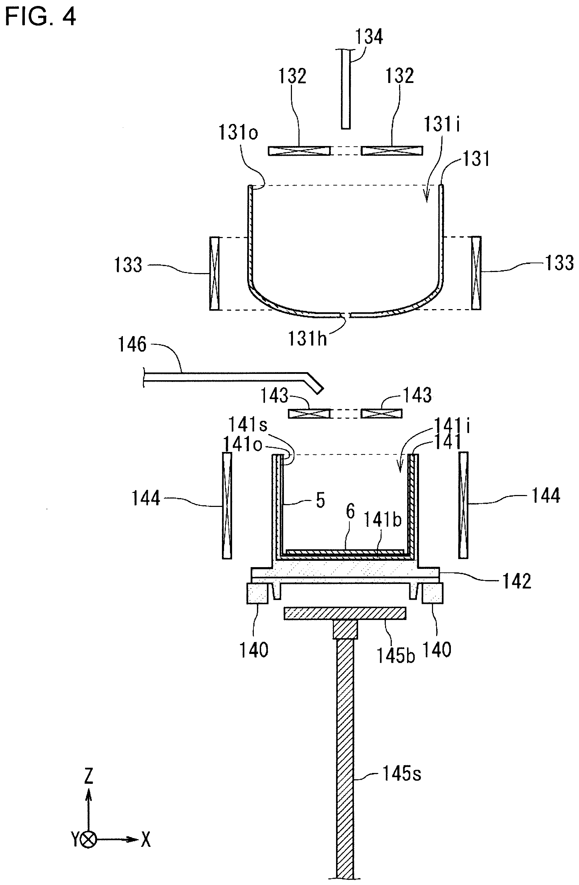

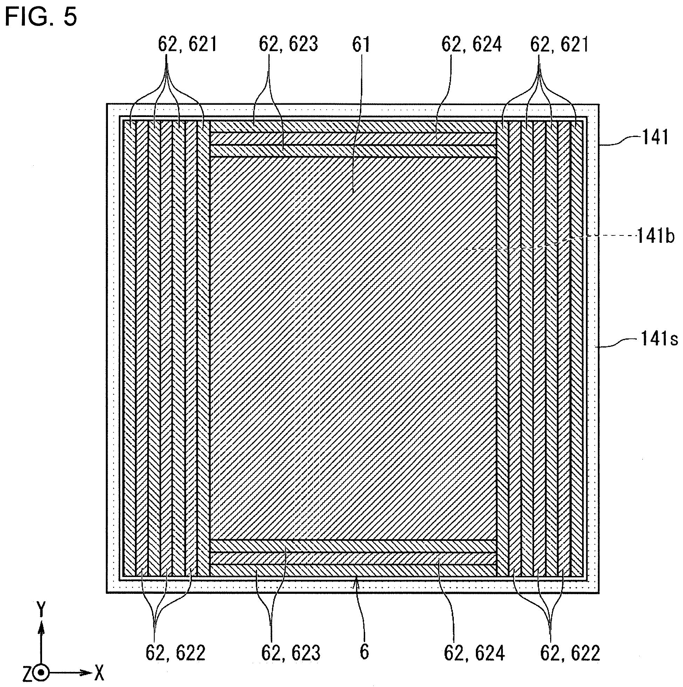

The third heater 143 can heat, for example, a silicon seed crystal assembly 6 (refer to, for example, FIGs. 4 and 5) and the silicon melt 72 in the second internal space 141i from above. The third heater 143 is located, for example, above the second internal space 141i of the mold 141. The third heater 143 is, for example, looped when viewed in plan in the negative Z-direction. Being looped includes being circular, triangular, quadrangular, or polygonal.

The fourth heaters 144 can heat, for example, the silicon seed crystal assembly 6 and the silicon melt 72 in the second internal space 141i from laterally. The mold 141 is, for example, between the fourth heaters 144. More specifically, the fourth heaters 144 are, for example, opposite to each other in X-direction with the mold 141 in between. The fourth heaters 144 may surround the mold 141 laterally. In other words, the fourth heaters 144 may be looped and surround the mold 141 when viewed in plan in the negative Z-direction.

The third heater 143 and the fourth heaters 144 may each be, for example, a graphite heater for resistance heating. One or more of the third heater 143 and the fourth heaters 144 may be, for example, a heater other than a graphite heater for resistance heating. The third heater 143 and the fourth heaters 144 may each generate heat using, for example, power supplied under control by the controller 15. Each of the fourth heaters 144 may be, for example, divided into multiple vertical sections. The heat generation of the multiple sections may be controlled individually. The third heater 143 and the fourth heaters 144 are fixed to the housing 11 with a heat-resistant member such as a graphite member in between.

The cooler 145 includes, for example, a cooling plate 145b, a rotational shaft 145s, and a drive 145m. The cooling plate 145b is fixed to the upper end of the rotational shaft 145s. The rotational shaft 145s extends vertically.

The rotational shaft 145s can be raised, lowered, and rotated with a driving force from the drive 145m. The rotational shaft 145s may be raised and lowered vertically in the longitudinal direction of the rotational shaft 145s. The rotational shaft 145s may rotate about an imaginary axis extending vertically and including the center of an XY cross section of the rotational shaft 145s. The XY cross section of the rotational shaft 145s is an imaginary cross section in an XY plane parallel to a horizontal plane. The drive 145m may include, for example, a cylinder to raise and lower the rotational shaft 145s and a motor to rotate the rotational shaft 145s.

The cooling plate 145b can be raised as the rotational shaft 145s is raised and lowered as the rotational shaft 145s is lowered. The cooling plate 145b may be, for example, raised as the rotational shaft 145s is raised to come in contact with the lower surface of the holder 142. The cooling plate 145b may be lowered as the rotational shaft 145s is lowered to separate from the lower surface of the holder 142.

The cooling plate 145b and the rotational shaft 145s each include a flow passage through which a refrigerant such as water flows in a member made of, for example, a metal with high thermal conductivity such as stainless steel. During the manufacture of the silicon ingot 2 using the manufacturing apparatus 1, for example, the cooling plate 145b may come in contact with the lower surface of the holder 142 to cool the silicon melt 72 in the second internal space 141i of the mold 141. During the cooling, heat from the silicon melt 72 transfers through, for example, the bottom 141b of the mold 141 and the holder 142 to the cooling plate 145b. The cooling plate 145b thus cools, for example, the silicon melt 72 from its portion near the bottom 141b. This allows the silicon melt 72 to solidify upward (also referred to as unidirectional solidification) in the second internal space 141i of the mold 141.

As the rotational shaft 145s is raised, the cooling plate 145b can push the holder 142 mounted on a mount 140 upward to lift the mold 141 and the holder 142. The mount 140 is fixed to the housing 11, and may receive the two ends of the lower surface of the holder 142.

While lifting the mold 141 and the holder 142, the cooling plate 145b can rotate the mold 141 and the holder 142 about the rotational shaft 145s as the rotational shaft 145s rotates. During the manufacture of the silicon ingot 2 using the manufacturing apparatus 1, the mold 141 can thus be rotated about, for example, the rotational shaft 145s. This reduces natural convection in the silicon melt 72 in the second internal space 141i.

The second gas feeder 146 can feed an inert gas into the second internal space 141i through the second upper opening 141o. The second gas feeder 146 includes a pipe (also referred to as a second feed pipe) that can blow the inert gas into the second internal space 141i from above. The inert gas may be, for example, an argon (Ar) gas. The inert gas may be a noble gas other than argon or may be a nitrogen gas. In FIG. 1, an imaginary thin two-dot-dash arrow indicates the inert gas blown from the second gas feeder 146 into the second internal space 141i.

The discharger 147 can discharge air from the housing 11. The discharger 147 may be, for example, a discharge pipe. The discharge pipe connects the internal space and the external space of the housing 11. In response to, for example, the inert gas fed from the first gas feeder 134 and the second gas feeder 146, the pressure in the internal space of the housing 11 increases higher than the pressure in the external space. The air may be discharged from the internal space to the external space through the discharger 147. This can reduce, for example, the partial pressure of oxygen in the internal space of the housing 11.

The controller 15 can control, for example, the overall operation of the manufacturing apparatus 1. The controller 15 includes, for example, a processor, a memory, and a storage. The controller 15 performs, for example, various control operations by executing a program stored in the storage using the processor.

The controller 15 can control, for example, heat generated by each of the first heater 132, the second heater 133, the third heater 143, and the fourth heaters 144. When one or more temperature measurers are located near the mold 141, the controller 15 can control heat generated by each of the first heater 132, the second heater 133, the third heater 143, and the fourth heaters 144 based on at least one of the temperature or the elapsed time obtained with the temperature measurers. The temperature measurers measure temperature with, for example, a thermocouple coated with a thin alumina or carbon tube. The controller 15 includes, for example, a temperature detector that detects the temperature corresponding to the voltage generated by each temperature measurer. For example, one temperature measurer may be located near the fourth heaters 144, or one temperature measurer may be located near the lower surface of a middle portion of the bottom 141b of the mold 141.

The controller 15 can also control, for example, the drive 145m to raise and lower the rotational shaft 145s. The controller 15 can control the drive 145m to raise and lower the rotational shaft 145s based on, for example, an elapsed time.

The controller 15 can also control, for example, the timing to start and stop feeding the inert gas from the first gas feeder 134 and the feed rate of the inert gas from the first gas feeder 134. The feed rate of the inert gas from the first gas feeder 134 may be controlled by, for example, adjusting the opening degree of a valve located on the passage from an inert gas source to the first feed pipe in response to a signal from the controller 15.

The controller 15 can also control, for example, the timing to start and stop feeding the inert gas from the second gas feeder 146 and the feed rate of the inert gas from the second gas feeder 146. The feed rate of the inert gas from the second gas feeder 146 may be controlled by, for example, adjusting the opening degree of a valve located on the passage from an inert gas source to the second feed pipe in response to a signal from the controller 15. 1-2. Manufacturing Method for Silicon Ingot

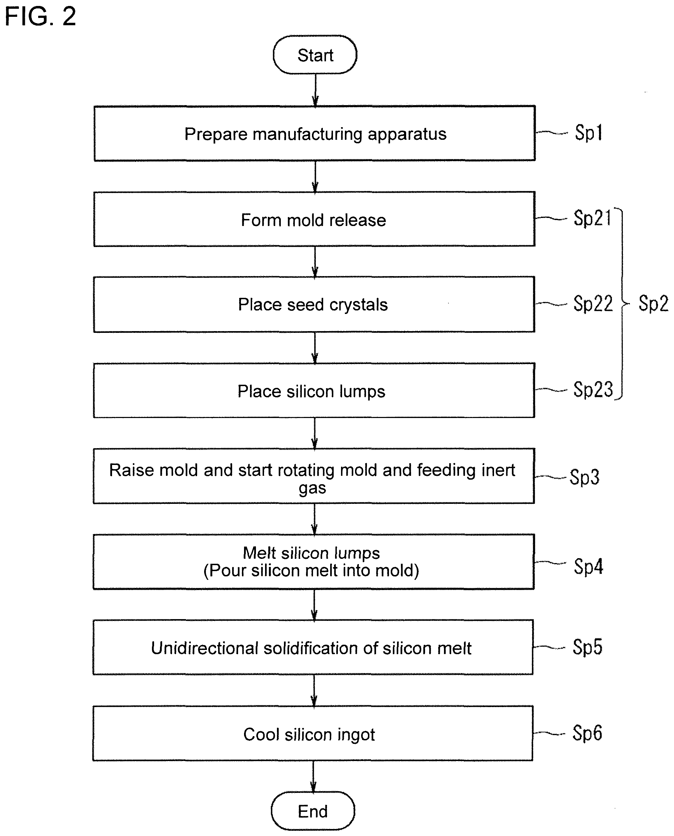

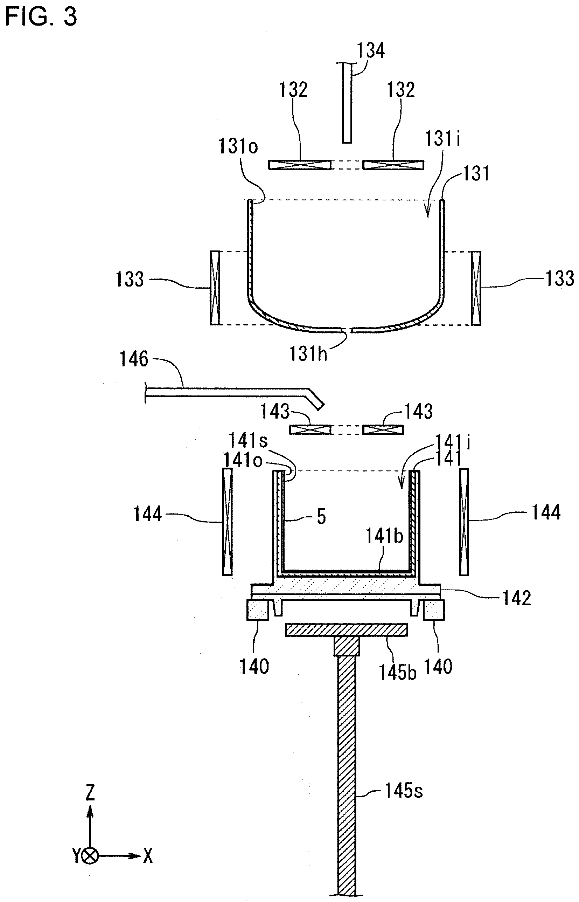

A manufacturing method for the silicon ingot 2 using the manufacturing apparatus 1 will be described with reference to FIGs. 2 to 13. As shown in FIG. 2, the manufacturing method for the silicon ingot 2 using the manufacturing apparatus 1 includes, for example, a first process in step Sp1, a second process in step Sp2, a third process in step Sp3, a fourth process in step Sp4, a fifth process in step Sp5, and a sixth process in Sp6 that are performed in this order. FIGs. 3, 4, 9, and 11 to 13 schematically illustrate the state of the first crucible 131, the mold 141, the holder 142, the cooling plate 145b, and the rotational shaft 145s, the feeding states of the inert gas from the first gas feeder 134 and the inert gas from the second gas feeder 146, and the heating state of the first heater 132, the second heater 133, the third heater 143, and the fourth heaters 144 in each process.

### 1-2-1. First Process

In the first process in step Sp1, the manufacturing apparatus 1 described above is prepared. The manufacturing apparatus 1 includes, for example, the mold 141 including the second upper opening 141o that is open in the positive Z-direction.

### 1-2-2. Second Process

In the second process in step Sp2, three steps, or specifically, step Sp21, step Sp22, and step Sp23, are performed in this order.

### Step Sp21

In step Sp21, as illustrated in the example in FIG. 3, a layer of a mold release (also referred to as a mold release layer) 5 is formed on the inner wall surface of the mold 141. The mold release layer 5 reduces, for example, the likelihood of the silicon ingot 2 fusing to the inner wall surface of the mold 141 when the silicon melt 72 solidifies in the mold 141. The mold release layer 5 reduces, when the silicon melt 72 is in the mold 141, the amount of oxygen (O) mixed into the silicon melt 72 from the mold 141. The mold release layer 5 may be made of, for example, silicon nitride (Si₃N₄), silicon oxide (SiO₂), and a binder. The mold release layer 5 may be, for example, a coating of slurry containing silicon nitride and silicon oxide and applied or sprayed to the inner wall surface of the mold 141. The slurry is prepared by, for example, adding a powder mixture of silicon nitride and silicon oxide to a solution mainly containing a solvent and an organic binder such as polyvinyl alcohol (PVA) or an inorganic binder such as colloidal silica, and stirring the resultant solution. The mold release layer 5 containing silicon nitride with a weight of about 1.5 to 9 times the weight of silicon oxide may reduce the likelihood that the strength of the mold release layer 5 decreases and the quality of the silicon ingot 2 deteriorates. The mold release layer 5 may be formed densely on the mold 141 by sputtering or chemical vapor deposition (CVD). This method further reduces the amount of oxygen (O) mixed into the silicon melt 72 from the mold 141 when the silicon melt 72 is in the mold 141. The mold release layer 5 may be made of a material other than the material containing silicon nitride and silicon oxide. The mold release layer 5 may be made of, for example, one or more materials selected from silicon nitride, silicon carbide, and silicon oxide.

### Step Sp22

In step Sp22, the silicon seed crystal assembly 6 is placed on the bottom 141b of the mold 141 as illustrated in FIGs. 4 and 5. More specifically, the silicon seed crystal assembly 6 is placed on the mold release layer 5 formed on the inner wall surface of the bottom 141b.

For example, the upper surface of the seed crystal assembly 6 facing in the positive Z-direction may have the Miller indices of (100). In this case, the seed crystal assembly 6 may be prepared easily. This may improve, for example, the crystal growth rate during unidirectional solidification of the silicon melt 72 described later. As illustrated in the example in FIG. 5, the upper surface of the seed crystal assembly 6 is rectangular or square when viewed in plan in the negative Z-direction. The seed crystal assembly 6 may be, for example, thick enough not to melt at the bottom 141b when the silicon melt 72 is poured into the mold 141 from the first crucible 131. More specifically, the seed crystal assembly 6 has a thickness of, for example, about 5 to 70 mm. The seed crystal assembly 6 may have a thickness of, for example, about 10 to 30 mm.

The seed crystal assembly 6 includes, for example, a main seed crystal 61 and multiple elongated rod-like seed crystals (also referred to as elongated seed crystals) 62 between the main seed crystal 61 and the side wall 141s. These may reduce defects in the silicon ingot 2. In the first embodiment, the main seed crystal 61 and the elongated seed crystals 62 contain monocrystalline silicon of the same material.

More specifically, the main seed crystal 61 is rectangular and has a pair of sides extending in X-direction and a pair of sides extending in Y-direction when viewed in plan in the negative Z-direction. In other words, the front and back surfaces of the main seed crystal 61 are rectangular. The front and back surfaces of the main seed crystal 61 include sides each measuring, for example, about 200 to 320 mm. The front and back surfaces of the main seed crystal 61 may be in any shape other than a rectangle, including a polygon. Each of the multiple elongated seed crystals 62 is in the shape of an elongated rectangle including a pair of sides extending in X-direction and a pair of sides extending in Y-direction when viewed in plan in the negative Z-direction. In other words, each of the front and back surfaces of the elongated seed crystals 62 is in the shape of an elongated rectangle.

A first predetermined number of elongated seed crystals 62 are placed between the main seed crystal 61 and the side wall 141s in the negative X-direction as the second direction from the main seed crystal 61. A second predetermined number of elongated seed crystals 62 are placed between the main seed crystal 61 and the side wall 141s in the positive X-direction from the main seed crystal 61. In other words, the first predetermined number of elongated seed crystals 62, the main seed crystal 61, and the second predetermined number of elongated seed crystals 62 are aligned in this order in the positive X-direction. The first predetermined number of elongated seed crystals 62 and the second predetermined number of elongated seed crystals 62 each have a longitudinal direction parallel to the positive Y-direction as the third direction. The first predetermined number of elongated seed crystals 62 and the second predetermined number of elongated seed crystals 62 each have a longitudinal length of, for example, about 200 to 400 mm parallel to the positive Y-direction, and a lateral length (also referred to as a width) of, for example, about 5 to 20 mm parallel to the positive X-direction. The first predetermined number of elongated seed crystals 62 and the second predetermined number of elongated seed crystals 62 may each include a single silicon monocrystal or two or more silicon monocrystals aligned in the positive Y-direction. The distance between the two or more silicon monocrystals may be, for example, about 0 to 3 mm or about 0 to 1 mm.

A third predetermined number of elongated seed crystals 62 are placed between the main seed crystal 61 and the side wall 141s in the negative Y-direction from the main seed crystal 61. A fourth predetermined number of elongated seed crystals 62 are placed between the main seed crystal 61 and the side wall 141s in the positive Y-direction from the main seed crystal 61. In other words, the third predetermined number of elongated seed crystals 62, the main seed crystal 61, and the fourth predetermined number of elongated seed crystals 62 are aligned in this order in the positive Y-direction. The third predetermined number of elongated seed crystals 62 and the fourth predetermined number of elongated seed crystals 62 each have a longitudinal direction parallel to the positive X-direction. The third predetermined number of elongated seed crystals 62 and the fourth predetermined number of elongated seed crystals 62 each have a longitudinal length of, for example, about 200 to 400 mm parallel to the positive X-direction, and a lateral length (also referred to as a width) of, for example, about 5 to 20 mm parallel to the positive Y-direction. The third predetermined number of elongated seed crystals 62 and the fourth predetermined number of elongated seed crystals 62 may each include a single silicon monocrystal or two or more silicon monocrystals aligned in the positive X-direction. The distance between the two or more silicon monocrystals may be, for example, about 0 to 3 mm or about 0 to 1 mm.

In the example in FIG. 5, the first predetermined number is seven, the second predetermined number is seven, the third predetermined number is three, and the fourth predetermined number is three. The first predetermined number and the second predetermined number are not limited to seven, and may be one or two or more. The third predetermined number and the fourth predetermined number are not limited to three, and may be one or two or more.

The main seed crystal 61 and the elongated seed crystals 62 adjacent to the main seed crystal 61 have a first rotation angle relationship between them as an angular relationship in the rotation direction of their silicon monocrystals about an imaginary axis parallel to the positive Z-direction. Two of the first predetermined number of elongated seed crystals 62 adjacent to each other have a second rotation angle relationship between them as an angular relationship in the rotation direction of their silicon monocrystals about an imaginary axis parallel to the positive Z-direction. Two of the second predetermined number of elongated seed crystals 62 adjacent to each other have a third rotation angle relationship between them as an angular relationship in the rotation direction of their silicon monocrystals about an imaginary axis parallel to the positive Z-direction. Two of the third predetermined number of elongated seed crystals 62 adjacent to each other have a fourth rotation angle relationship between them as an angular relationship in the rotation direction of their silicon monocrystals about an imaginary axis parallel to the positive Z-direction. Two of the fourth predetermined number of elongated seed crystals 62 adjacent to each other have a fifth rotation angle relationship between them as an angular relationship in the rotation direction of their silicon monocrystals about an imaginary axis parallel to the positive Z-direction.

In this case, in step Sp22, the seed crystal assembly 6 is placed to cause each of the first rotation angle relationship, the second rotation angle relationship, the third rotation angle relationship, the fourth rotation angle relationship, and the fifth rotation angle relationship to be, for example, the angular relationship in the rotation direction of the silicon monocrystals corresponding to a coincidence boundary. The coincidence boundary refers to a grain boundary that may occur between two adjacent crystal grains having the same crystal lattices and having the relationship of being rotated relative to each other about a rotation axis parallel to their shared crystal direction. When the crystal lattices shared by the two crystal grains are located to form lattice points arranged regularly, the grain boundary is referred to as a coincidence boundary. The two adjacent crystal grains across the coincidence boundary may be referred to as a first crystal grain and a second crystal grain. When the crystal lattices in the first crystal grain have lattice points shared by the crystal lattices in the second crystal grain for every N (N is a natural number greater than or equal to 2) lattice points at the coincidence boundary, the numerical value N indicating the frequency of such lattice points is referred to as a Σ value of the coincidence boundary.

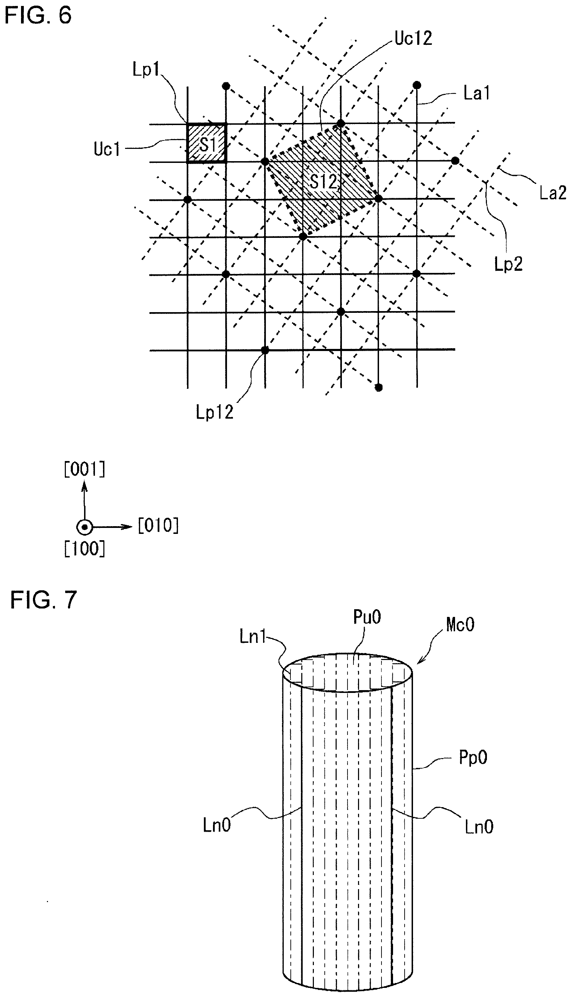

The Σ value will be described using a simple cubic lattice as an example. In FIG. 6, the simple cubic lattice has lattice points Lp1 on a plane having the Miller indices of (100) at intersections between multiple vertical and horizontal solid lines La1 orthogonal to each other. In the example in FIG. 6, the square defined by the thick solid line is a unit cell (also referred to as a first unit cell) Uc1 of the simple cubic lattice. In FIG. 6, the simple cubic lattice is rotated clockwise by 36.52 degrees (36.52°) about a crystal axis parallel to a direction having the Miller indices of [100] as a rotation axis. The resultant simple cubic lattice has lattice points Lp2 on a plane having the Miller indices of (100) at intersections of multiple straight broken lines La2 orthogonal to each other. A point (also referred to as a coincidence lattice point) Lp12 at which a lattice point Lp1 before rotation overlaps a lattice point Lp2 after rotation occurs periodically. In FIG. 6, the solid circles indicate the periodically-occurring coincidence lattice points Lp12. In the example in FIG. 6, multiple coincidence lattice points Lp12 form a lattice (also referred to as a coincidence lattice) including a unit cell (also referred to as a coincidence unit cell) Uc12 indicated by the square defined by the thick broken line. The Σ value is used as an index indicating the degree of coincidence (the density of coincidence lattice points) between the simple cubic lattice before rotation (also referred to as a first lattice) including its lattice points Lp1 at the intersections between the solid lines La1 and the simple cubic lattice after rotation (also referred to as a second lattice) including its lattice points Lp2 at the intersections between the broken lines La2. In the example in FIG. 6, the Σ value may be calculated by dividing an area S12 of the coincidence unit cell Uc12 by an area S1 of the first unit cell Uc1. More specifically, the Σ value may be calculated by the formula Σ value = (the area of the coincidence unit cell)/(the area of the first unit cell) = (S12)/(S1). In the example in FIG. 6, the calculated Σ value is 5. The Σ value may be used as an index indicating the degree of coincidence between the first lattice and the second lattice adjacent to each other across a grain boundary with a predetermined angular relationship between them in the rotation direction. More specifically, the Σ value may be used as an index indicating the degree of coincidence between two adjacent crystal grains across a grain boundary having a predetermined angular relationship in the rotation direction and having the same crystal lattices.

The angular relationship in the rotation direction of silicon monocrystals corresponding to the coincidence boundary may allow an error margin of, for example, 1 to 3 degrees. The error may occur when, for example, cutting and preparing the main seed crystal 61 and the elongated seed crystals 62 and when arranging the main seed crystal 61 and the elongated seed crystals 62. Such errors may be reduced during, for example, the unidirectional solidification of the silicon melt 72 described later.

For example, the upper surface of each of the main seed crystal 61 and the elongated seed crystals 62 facing in the positive Z-direction has the Miller indices of (100). In other words, the crystal direction of each of the main seed crystal 61 and the elongated seed crystals 62 in the positive Z-direction has, for example, the Miller indices of <100>. In this case, the coincidence boundary is one of a Σ5 coincidence boundary, a Σ13 coincidence boundary, a Σ17 coincidence boundary, a Σ25 coincidence boundary, or a Σ29 coincidence boundary. The angular relationship in the rotation direction of silicon monocrystals corresponding to the Σ5 coincidence boundary may be, for example, about 36 to 37 degrees or about 35 to 38 degrees. The angular relationship in the rotation direction of silicon monocrystals corresponding to the Σ13 coincidence boundary may be, for example, about 22 to 23 degrees or about 21 to 24 degrees. The angular relationship in the rotation direction of silicon monocrystals corresponding to the Σ17 coincidence boundary may be, for example, about 26 to 27 degrees or about 25 to 28 degrees. The angular relationship in the rotation direction of silicon monocrystals corresponding to the Σ25 coincidence boundary may be, for example, about 16 to 17 degrees or about 15 to 18 degrees. The angular relationship in the rotation direction of silicon monocrystals corresponding to the Σ29 coincidence boundary (also referred to as a random boundary) may be, for example, about 43 to 44 degrees or about 42 to 45 degrees. The crystal direction of each of the main seed crystal 61 and the elongated seed crystals 62 may be identified by measurement using, for example, X-ray diffraction or electron backscatter diffraction (EBSD).

The main seed crystal 61 and the elongated seed crystals 62 are arranged with, for example, the upper surfaces of the silicon crystals having the Miller indices of (100) facing in the positive Z-direction. This may improve, for example, the crystal growth rate during the unidirectional solidification of the silicon melt 72 described later. Thus, pseudo-monocrystals are obtained easily by growing crystal grains upward from each of the main seed crystal 61 and the elongated seed crystals 62. The quality of the silicon ingot 2 may thus be improved easily.

The first rotation angle relationship between the main seed crystal 61 and the elongated seed crystals 62 adjacent to the main seed crystal 61 may be set to, for example, 45 degrees corresponding to a Σ29 coincidence boundary. In this case, for example, the crystal direction of the main seed crystal 61 in the positive X-direction may have the Miller indices of <100>. The crystal direction of the elongated seed crystals 62 adjacent to the main seed crystal 61 in the positive X-direction may have the Miller indices of <110>.

For the first predetermined number of elongated seed crystals 62 located in the negative X-direction from the main seed crystal 61, the second rotation angle relationship between two elongated seed crystals 62 in each pair of elongated seed crystals 62 adjacent to each other in the negative X-direction may be set to, for example, 45 degrees corresponding to a Σ29 coincidence boundary. The first predetermined number of elongated seed crystals 62 include first elongated seed crystals 621 at odd positions in the negative X-direction from the main seed crystal 61. The first predetermined number of elongated seed crystals 62 include second elongated seed crystals 622 at even positions in the negative X-direction from the main seed crystal 61. In this case, for example, the crystal direction of the first elongated seed crystals 621 parallel to the negative X-direction has the Miller indices of <110>. The crystal direction of the second elongated seed crystals 622 parallel to the negative X-direction has the Miller indices of <100>.

For the second predetermined number of elongated seed crystals 62 located in the positive X-direction from the main seed crystal 61, the third rotation angle relationship between the two elongated seed crystals 62 in each pair of elongated seed crystals 62 adjacent to each other in the positive X-direction may be set to, for example, 45 degrees corresponding to a Σ29 coincidence boundary. The second predetermined number of elongated seed crystals 62 include first elongated seed crystals 621 at odd positions in the positive X-direction from the main seed crystal 61. The second predetermined number of elongated seed crystals 62 include second elongated seed crystals 622 at even positions in the positive X-direction from the main seed crystal 61. In this case, for example, the crystal direction of the first elongated seed crystals 621 parallel to the positive X-direction has the Miller indices of <110>. The crystal direction of the second elongated seed crystals 622 parallel to the positive X-direction has the Miller indices of <100>.

For the third predetermined number of elongated seed crystals 62 located in the negative Y-direction from the main seed crystal 61, the fourth rotation angle relationship between the two elongated seed crystals 62 in each pair of elongated seed crystals 62 adjacent to each other in the negative Y-direction may be set to, for example, 45 degrees corresponding to a Σ29 coincidence boundary. The third predetermined number of elongated seed crystals 62 include third elongated seed crystals 623 at odd positions in the negative Y-direction from the main seed crystal 61. The third predetermined number of elongated seed crystals 62 include fourth elongated seed crystals 624 at even positions in the negative Y-direction from the main seed crystal 61. In this case, for example, the crystal direction of the third elongated seed crystals 623 parallel to the negative Y-direction has the Miller indices of <110>. The crystal direction of the fourth elongated seed crystals 624 parallel to the negative Y-direction has the Miller indices of <100>.

For the fourth predetermined number of elongated seed crystals 62 located in the positive Y-direction from the main seed crystal 61, the fifth rotation angle relationship between the two elongated seed crystals 62 in each pair of elongated seed crystals 62 adjacent to each other in the positive Y-direction may be set to, for example, 45 degrees corresponding to a Σ29 coincidence boundary. The fourth predetermined number of elongated seed crystals 62 include third elongated seed crystals 623 at odd positions in the positive Y-direction from the main seed crystal 61. The fourth predetermined number of elongated seed crystals 62 include fourth elongated seed crystals 624 at even positions in the positive Y-direction from the main seed crystal 61. In this case, for example, the crystal direction of the third elongated seed crystals 623 parallel to the positive Y-direction has the Miller indices of <110>. The crystal direction of the fourth elongated seed crystals 624 parallel to the positive Y-direction has the Miller indices of <100>.

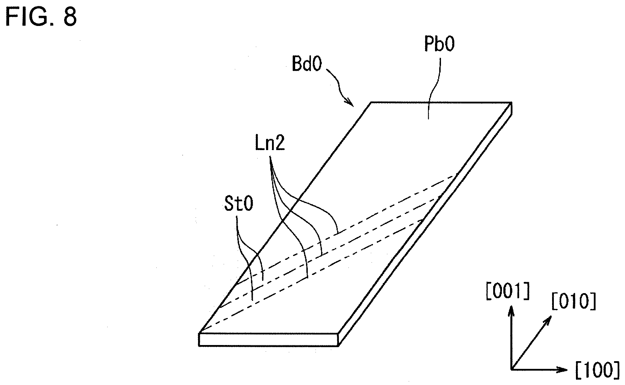

The main seed crystal 61 and the elongated seed crystals 62 may be prepared with, for example, a procedure described below. As illustrated in the example in FIG. 7, a cylindrical lump of monocrystalline silicon (also referred to as a monocrystalline silicon lump) Mc0 is first obtained using the Czochralski (CZ) method by setting the crystal direction parallel to the direction in which the monocrystalline silicon is grown to have the Miller indices of <100>. In this example, the monocrystalline silicon lump Mc0 includes an upper surface Pu0 having the Miller indices of (100) and an outer peripheral surface Pp0 including specific linear portions Ln0 having the Miller indices of (110). As illustrated in FIG. 7, the monocrystalline silicon lump Mc0 is then cut with reference to the linear portions Ln0 on the outer peripheral surface Pp0 of the monocrystalline silicon lump Mc0. In FIG. 7, example positions at which the monocrystalline silicon lump Mc0 is cut (also referred to as cut positions) are indicated by imaginary thin two-dot-dash lines Ln1. As illustrated in FIG. 8, the monocrystalline silicon lump Mc0 may be, for example, cut into multiple plates Bd0 of monocrystalline silicon (also referred to as monocrystalline silicon plates) each having a rectangular plate surface Pb0 having the Miller indices of (100). The monocrystalline silicon plates Bd0 may be used as, for example, the main seed crystal 61. As illustrated in FIG. 8, for example, the monocrystalline silicon plate Bd0 may be cut along the cut positions indicated by imaginary thin two-dot-dash lines Ln2 into rods St0 of monocrystalline silicon (also referred to as monocrystalline silicon rods). The angle between one of the four sides of the plate surface Pb0 of the monocrystalline silicon plate Bd0 and one of the thin two-dot-dash lines Ln2 is the rotation angle of silicon monocrystals corresponding to a coincidence boundary. Each monocrystalline silicon rod St0 obtained as described above may be used as, for example, an elongated seed crystal 62.

In the lower portion of the second internal space 141i of the mold 141, one or more silicon lumps 71 may be placed on the silicon seed crystal assembly 6 placed on the bottom 141b of the mold 141. Such silicon lumps 71 are, for example, relatively small blocks of silicon.

### Step Sp23

In step Sp23, as illustrated in FIG. 9, multiple silicon lumps 71 are placed in the first internal space 131i of the first crucible 131. The multiple silicon lumps 71 are, for example, placed from the lower space toward the upper space of the first crucible 131. The multiple silicon lumps 71 placed into the first crucible 131 is mixed with, for example, an element to be a dopant in the silicon ingot 2. The silicon lumps 71 are, for example, polysilicon lumps as a raw material of the silicon ingot 2. The polysilicon lumps are, for example, relatively small blocks of silicon. To obtain the n-type silicon block 3 and the n-type silicon substrate 4 from the silicon ingot 2, a group 15 element as an n-type dopant is added to the silicon lumps 71.

During the manufacture of the silicon ingot 2 through solidification of the silicon melt 72, the dopant segregates as an impurity element. The segregation of the dopant in silicon refers to nonuniform distribution of the dopant in the silicon ingot 2 through solidification of the silicon melt 72, which is in the ideal state of having no change in the impurity amount through, for example, evaporation and being thoroughly agitated. The segregation may cause the silicon melt 72 to contain less dopant in a portion that solidifies first and more dopant in a portion that solidifies later. A segregation coefficient is known as an index to indicate the likelihood of the segregation. The segregation coefficient is also referred to as an equilibrium distribution coefficient K0. At the interface between the solid phase and the liquid phase of a substance, the equilibrium distribution coefficient K0 is defined by the formula K0 = Cs/Cl, where Cs is the concentration of impurities in the solid phase and Cl is the concentration of impurities in the liquid phase. Thus, the dopant having a segregation coefficient in silicon closer to 1 may be contained more uniformly in the silicon ingot 2 manufactured through unidirectional solidification of the silicon melt 72.

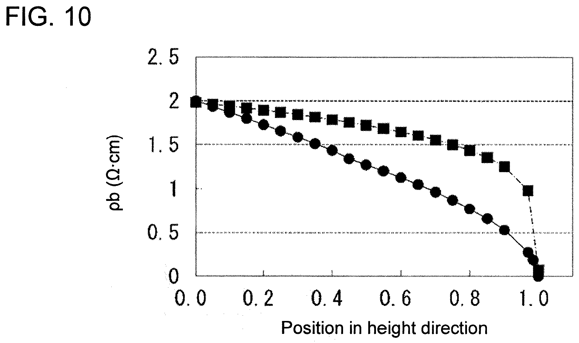

In an example below, p-type silicon blocks and p-type silicon substrates are obtained from a silicon ingot manufactured by casting using boron (B) that is a group 13 element as a p-type dopant. In this case, the segregation coefficient of boron (B) in silicon is about 0.8. FIG. 10 shows an example relationship between the position in the height direction of the silicon ingot manufactured by casting with boron (B) added as the p-type dopant to silicon and the resistivity (ρb) at the position, plotted with solid squares. In this example, boron (B) is added to silicon in an amount to cause the lower portion of the silicon ingot to have a resistivity (ρb) of 2 ohm-centimeters (Ω·cm). FIG. 10 shows the position in the height direction of the silicon ingot with 0 indicating the lowermost portion and 1 indicating the uppermost portion. As shown in FIG. 10, the silicon ingot manufactured by upward unidirectional solidification of the silicon melt has a resistivity (ρb) of 1 to 2 Ω·cm in about a 97% portion of the silicon ingot from the bottom. Thus, the silicon ingot manufactured by casting or mono-like casting allows p-type silicon blocks and p-type silicon substrates obtained from the silicon ingot to have an intended resistivity (ρb) in a wider portion.

In another example, n-type silicon blocks and n-type silicon substrates are obtained from a silicon ingot manufactured by casting using phosphorus (P) that is a group 15 element as an n-type dopant. In this case, the segregation coefficient of phosphorus (P) in silicon is about 0.35. FIG. 10 shows an example relationship between the position in the height direction of the silicon ingot manufactured by casting with phosphorus (P) added as the n-type dopant to silicon and the resistivity (ρb) at the position, plotted with solid circles. In this example, phosphorus (P) is added to silicon in an amount to cause the lower portion of the silicon ingot to have a resistivity (ρb) of 2 Ω·cm. As shown in FIG. 10, the silicon ingot manufactured by upward unidirectional solidification of the silicon melt has a resistivity (ρb) of 1 to 2 Ω·cm in about a 65% portion of the silicon ingot from the bottom. Thus, the silicon ingot manufactured by casting or mono-like casting allows n-type silicon block and n-type silicon substrate obtained from the silicon ingot to have an intended resistivity (ρb) in a smaller portion. In other words, the silicon ingot manufactured by casting or mono-like casting has low productivity of n-type silicon blocks and n-type silicon substrates.

In step Sp23, the silicon lumps 71 are mixed with a group 13 element as the p-type dopant as well as with a group 15 element as the n-type dopant. The group 13 element, which has a smaller segregation coefficient in silicon than the group 15 element, is used. The silicon melt 72 thus has a higher concentration of the p-type dopant as well as a higher concentration of the n-type dopant as it solidifies unidirectionally. The silicon melt 72 may then gradually solidify with the electric charge of the p-type dopant canceling a part of excess electric charge of the n-type dopant. The mutual cancellation of the electric charge between the n-type dopant and the p-type dopant is also referred to as compensation. This allows the silicon ingot 2 manufactured through the unidirectional solidification of the silicon melt 72 to contain n-type silicon having an intended resistivity (ρb) in a wider portion. In other words, n-type silicon blocks and the n-type silicon substrates having an intended resistivity (ρb) are obtained from a wider portion of the silicon ingot 2 manufactured by the unidirectional solidification of the silicon melt 72.

The group 15 element to be added to the silicon lumps 71 is at least one element selected from the group consisting of phosphorus (P), arsenic (As), and antimony (Sb). The group 13 element to be added to the silicon lumps 71 is at least one element selected from the group consisting of aluminum (Al), gallium (Ga), and indium (In). The segregation coefficient of arsenic (As) in silicon is about 0.3. The segregation coefficient of antimony (Sb) in silicon is about 0.023. The segregation coefficient of aluminum (Al) in silicon is 0.002. The segregation coefficient of gallium (Ga) in silicon is 0.008. The segregation coefficient of indium (In) in silicon is 0.0004.

Phosphorus (P), aluminum (Al), and gallium (Ga) are easily available. The elements other than arsenic (As) and indium (In) are less likely to evaporate from the silicon melt 72 and are easy to handle. Indium (In) is costly and thus is not easily available. Phosphorus (P) and arsenic (As) have a greater segregation coefficient than antimony (Sb). Thus, the use of phosphorus (P) or arsenic (As) as a group 15 element to be added to silicon can reduce the amount of the group 15 element to be added to silicon. When an element other than aluminum (Al) is used as a group 13 element to be added to silicon, the n-type silicon block 3 and the n-type silicon substrate 4 may have higher quality. Thus, the use of phosphorus (P) as the group 15 element and gallium (Ga) as the group 13 element facilitates the manufacture of high quality n-type silicon blocks 3 and n-type silicon substrates 4.

The group 15 element and the group 13 element are added to silicon at a ratio to achieve an intended silicon resistivity (ρb). For example, the amount of substance (number of moles) of the group 13 element added to the silicon lumps 71 is set to about 1/2 to 1/3 the amount of substance (number of moles) of the group 15 element added to the silicon lumps 71. The intended silicon resistivity (ρb) is set to, for example, 1 to 3 Ω·cm. In this example, silicon lumps mixed with the group 15 element at a high concentration and the group 13 element may be placed in the top portion of the silicon lumps 71.

In step Sp23, a silicon lump 71o (also referred to as a closing silicon lump) is, for example, placed to close the first lower opening 131h in the first crucible 131 from above. This closes, for example, the path from the first internal space 131i to the first lower opening 131h.

### 1-2-3. Third Process

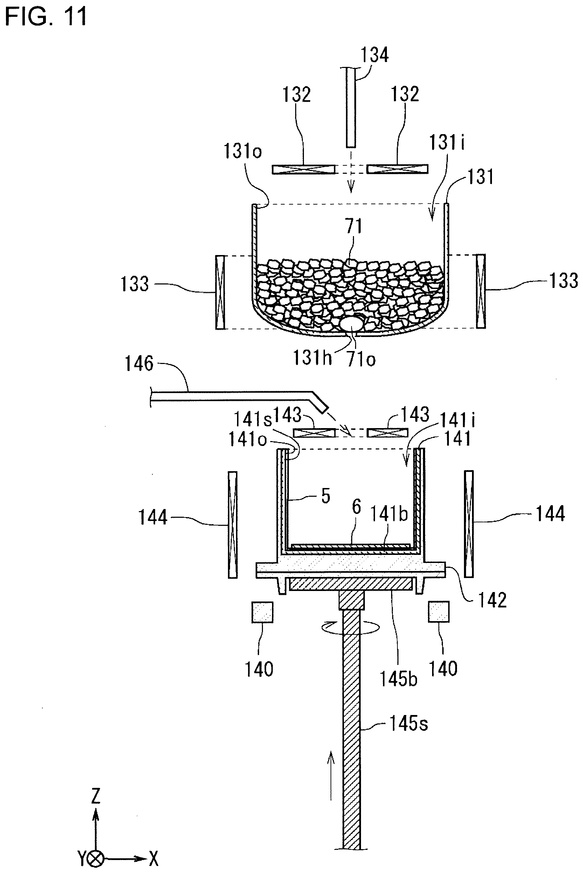

In the third process in step Sp3, as illustrated in the example in FIG. 11, the cooling plate 145b is raised to press the upper surface of the cooling plate 145b against the lower surface of the holder 142 and to push the holder 142 upward. The cooling plate 145b thus lifts the mold 141 and the holder 142. The mold 141 and the holder 142 then start rotating about the rotational shaft 145s. The rotation of the mold 141 and the holder 142 is caused by, for example, the rotation of the cooling plate 145b in response to the rotation of the rotational shaft 145s. As illustrated in, for example, FIG. 11, the third process in step Sp3 includes feeding, with the first gas feeder 134, the inert gas toward the first internal space 131i and feeding, with the second gas feeder 146, the inert gas toward the second internal space 141i.

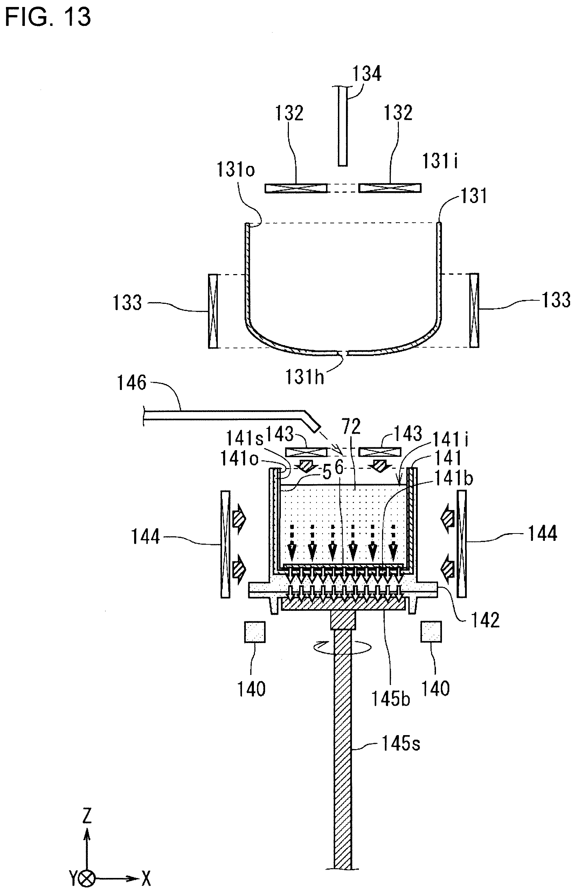

In FIG. 11, the thin solid arrows schematically indicate the lifting of the rotational shaft 145s and the rotation of the cooling plate 145b. The two-dot-dash arrows schematically indicate the inert gas fed from the first gas feeder 134 and the inert gas fed from the second gas feeder 146. In FIGs. 12 and 13, the thin solid arrow schematically indicates the rotation of the rotational shaft 145s and the cooling plate 145b. The thin two-dot-dash arrows schematically indicate the inert gas fed from the first gas feeder 134 and the inert gas fed from the second gas feeder 146.

### 1-2-4. Fourth Process

In the fourth process in step Sp4, for example, the seed crystal assembly 6 placed on the bottom 141b of the mold 141 in the second process is heated to around the melting point of silicon, and then the silicon melt 72 is poured into the mold 141. The melting point of silicon is about 1414 degrees Celsius (1414 °C).

In the fourth process, as illustrated in the example in FIG. 12, the seed crystal assembly 6 on the bottom 141b of the mold 141 is heated to around the melting point of silicon. For example, the third heater 143 and the fourth heaters 144 heat the seed crystal assembly 6 to around 1414 °C or the melting point of silicon. In FIG. 12, hatched arrows schematically indicate heat from the third heater 143 and the fourth heaters 144.

More specifically, for example, the third heater 143 and the fourth heaters 144 heat a portion of the upper surface of the seed crystal assembly 6 to a temperature range exceeding the melting point of silicon. The upper surface portion of the seed crystal assembly 6 thus melts. In this state, the temperature of the upper surface portion of the seed crystal assembly 6 may reach, for example, about 1530 °C. The cooling plate 145b is in contact with the lower surface of the holder 142. Thus, the bottom 141b and the holder 142 transfers heat from the seed crystal assembly 6 to the cooling plate 145b to cause heat transfer from the seed crystal assembly 6 to the cooling plate 145b through the bottom 141b and the holder 142. The lower surface portion of the seed crystal assembly 6 thus remains without melting. In FIG. 12, the outlined arrows schematically indicate the heat transfer from the seed crystal assembly 6 to the cooling plate 145b through the bottom 141b and the holder 142. The second process may include, for example, placing the silicon lumps 71 on the seed crystal assembly 6 placed on the bottom 141b of the mold 141. In this case, the silicon lumps 71 may be melted by the third heater 143 and the fourth heaters 144.

In the fourth process, as illustrated in the example in FIG. 12, the silicon lumps 71 located in the first crucible 131 are heated and melted to be the silicon melt 72 contained in the first crucible 131. For example, the first heater 132 and the second heater 133 heat the silicon lumps 71 to a temperature range exceeding the melting point of silicon to provide the silicon melt 72. In FIG. 12, the arrows hatched with oblique lines indicate heat from the first heater 132 and the second heater 133.

More specifically, for example, the first heater 132 and the second heater 133 heat the silicon lumps 71 to a temperature range exceeding the melting point of silicon. The silicon lumps 71 thus melt. The temperature of the silicon melt 72 resulting from melting of the silicon lumps 71 may reach, for example, about 1550 °C. The closing silicon lump 71o closing the first lower opening 131h in the first crucible 131 from above is heated and thus melts. The closing silicon lump 71o may be melted by a dedicated heater. The closing silicon lump 71o is melted to open the path from the first internal space 131i of the first crucible 131 to the first lower opening 131h. The silicon melt 72 in the first crucible 131 is thus poured into the mold 141 through the first lower opening 131h. Thus, as illustrated in the example in FIG. 12, the upper surface of the seed crystal assembly 6 on the bottom 141b of the mold 141 is covered with the silicon melt 72.

After the silicon melt 72 in the first crucible 131 is fully poured into the mold 141, the first heater 132 and the second heater 133 are stopped from heating. In some embodiments, after the silicon melt 72 in the first crucible 131 is fully poured into the mold 141, the first gas feeder 134 may be stopped from feeding the inert gas toward the first internal space 131i.

When the first heater 132, the second heater 133, the third heater 143, and the fourth heaters 144 are made of graphite, a carbon monoxide (CO) gas may be generated from the first heater 132, the second heater 133, the third heater 143, and the fourth heaters 144 heating the seed crystal assembly 6 and the silicon lumps 71 in the fourth process. The silicon melt 72 may thus be mixed with carbon monoxide (CO). Carbon monoxide (CO) mixed in the silicon melt 72 is less likely to evaporate. This may increase the number of carbon (C) atoms per unit volume in the silicon melt 72. The unit volume is, for example, one cubic centimeter (cm³).

In the fourth process, the inert gas fed from the first gas feeder 134 toward the first internal space 131i may increase evaporation of oxygen (O) from the silicon melt 72 in the first internal space 131i and reduce the number of oxygen (O) atoms per unit volume (also referred to as oxygen concentration) in the silicon melt 72 in the first internal space 131i. The inert gas fed from the first gas feeder 134 toward the first internal space 131i per unit time may be increased to further increase the evaporation of oxygen (O) from the silicon melt 72 in the first internal space 131i. This may further reduce the number of oxygen (O) atoms per unit volume in the silicon melt 72 in the first internal space 131i. The housing 11 may be, for example, decompressed to increase the evaporation of oxygen (O) from the silicon melt 72 in the first internal space 131i to reduce the number of oxygen (O) atoms per unit volume in the silicon melt 72 in the first internal space 131i.

In the fourth process, the inert gas fed from the second gas feeder 146 toward the second internal space 141i may increase evaporation of oxygen (O) from the silicon melt 72 in the second internal space 141i, reducing the number of oxygen (O) atoms per unit volume in the silicon melt 72 in the second internal space 141i. The amount of inert gas fed from the second gas feeder 146 toward the second internal space 141i per unit time may be increased to further increase the evaporation of oxygen (O) from the silicon melt 72 in the second internal space 141i. This may further reduce the number of oxygen (O) atoms per unit volume in the silicon melt 72 in the second internal space 141i. The housing 11 may be, for example, decompressed to increase the evaporation of oxygen (O) from the silicon melt 72 in the second internal space 141i to reduce the number of oxygen (O) atoms per unit volume in the silicon melt 72 in the second internal space 141i.

### 1-2-5. Fifth Process

In the fifth process in step Sp5, for example, the silicon melt 72 poured into the mold 141 in the fourth process is solidified unidirectionally (unidirectional solidification) upward from the bottom 141b of the mold 141. This may form the silicon ingot 2.

In the fifth process, as illustrated in the example in FIG. 13, the temperature of the silicon melt 72 in the mold 141 is maintained at around the melting point of silicon, and heat is transferred from the silicon melt 72 in the mold 141 to the cooling plate 145b through the bottom 141b and the holder 142. This cools the silicon melt 72 in the mold 141 from the bottom 141b, causing unidirectional solidification of the silicon melt 72 upward from the bottom 141b. The temperature of the silicon melt 72 in the mold 141 is set to, for example, about 1405 °C that is lower than the melting point of silicon of 1414 °C. In FIG. 13, hatched arrows schematically indicate heat from the third heater 143 and the fourth heaters 144 as in FIG. 12. In FIG. 13, as in FIG. 12, the outlined arrows schematically indicate, as images, heat transfer from the seed crystal assembly 6 to the cooling plate 145b through the bottom 141b and the holder 142. In FIG. 13, the thick dashed arrows indicate heat transfer in the silicon melt 72.

In the fifth process, for example, the silicon melt 72 is slowly solidified unidirectionally into the silicon ingot 2 in the mold 141. During the solidification, for example, a pseudo-monocrystal grows from the seed crystal assembly 6. More specifically, for example, a pseudo-monocrystal grows from each of the main seed crystal 61 and the elongated seed crystals 62 included in the seed crystal assembly 6.

In this process, a grain boundary (functional grain boundary) including a coincidence boundary may form at the boundary between the pseudo-monocrystal grown from the main seed crystal 61 and the pseudo-monocrystal grown from each elongated seed crystal 62 adjacent to the main seed crystal 61 based on the first rotation angle relationship inherited from the main seed crystal 61 and the elongated seed crystal 62. In other words, a coincidence boundary may form above the boundary between the main seed crystal 61 and each elongated seed crystal 62 adjacent to the main seed crystal 61.

For, for example, two elongated seed crystals 62 in each pair of elongated seed crystals 62 adjacent to each other in the negative X-direction included in the first predetermined number of elongated seed crystals 62 located in the negative X-direction from the main seed crystal 61, a grain boundary (functional grain boundary) including a coincidence boundary may form at the boundary between two pseudo-monocrystals grown from the two elongated seed crystals 62 based on the second rotation angle relationship inherited from the two elongated seed crystals 62. In other words, a coincidence boundary may form above the boundary between the two elongated seed crystals 62 in each pair of elongated seed crystal 62 adjacent to each other in the negative X-direction included in the first predetermined number of elongated seed crystals 62 located in the negative X-direction from the main seed crystal 61.

For, for example, two elongated seed crystals 62 in each pair of elongated seed crystals 62 adjacent to each other in the positive X-direction included in the second predetermined number of elongated seed crystals 62 located in the positive X-direction from the main seed crystal 61, a grain boundary (functional grain boundary) including a coincidence boundary may form at the boundary between two pseudo-monocrystals grown from the two elongated seed crystals 62 based on the third rotation angle relationship inherited from the two elongated seed crystals 62. In other words, a coincidence boundary may form above the boundary between the two elongated seed crystals 62 in each pair of elongated seed crystals 62 adjacent to each other in the positive X-direction included in the second predetermined number of elongated seed crystals 62 located in the positive X-direction from the main seed crystal 61.

For, for example, two elongated seed crystals 62 in each pair of elongated seed crystals 62 adjacent to each other in the negative Y-direction included in the third predetermined number of elongated seed crystals 62 located in the negative Y-direction from the main seed crystal 61, a grain boundary (functional grain boundary) including a coincidence boundary may form at the boundary between two pseudo-monocrystals grown from the two elongated seed crystals 62 based on the fourth rotation angle relationship inherited from the two elongated seed crystals 62. In other words, a coincidence boundary may form above the boundary between the two elongated seed crystals 62 in each pair of elongated seed crystals 62 adjacent to each other in the negative Y-direction included in the third predetermined number of elongated seed crystals 62 located in the negative Y-direction from the main seed crystal 61.

For, for example, two elongated seed crystals 62 in each pair of elongated seed crystals 62 adjacent to each other in the positive Y-direction included in the fourth predetermined number of elongated seed crystals 62 located in the positive Y-direction from the main seed crystal 61, a grain boundary (functional grain boundary) including a coincidence boundary may form at the boundary between two pseudo-monocrystals grown from the two elongated seed crystals 62 based on the fifth rotation angle relationship inherited from the two elongated seed crystals 62. In other words, a coincidence boundary may form above the boundary between the two elongated seed crystals 62 in each pair of elongated seed crystals 62 adjacent to each other in the positive Y-direction included in the fourth predetermined number of elongated seed crystals 62 located in the positive Y-direction from the main seed crystal 61.

When, for example, the coincidence boundaries form, distortions with the unidirectional solidification of the silicon melt 72 may be reduced. This reduces defects in the silicon ingot 2. The functional grain boundaries in a loop along the inner peripheral surface of the side wall 141s may obstruct, for example, development (propagation) of any dislocation from the inner peripheral surface of the side wall 141s of the mold 141 during the unidirectional solidification of the silicon melt 72. This may reduce defects in the pseudo-monocrystal grown from the main seed crystal 61. In other words, the resultant silicon ingot 2 may have fewer defects. The coincidence boundaries and the types of coincidence boundaries in the silicon ingot 2 may be identified by measurement using EBSD or other techniques.

In the fifth process, for example, the third heater 143 may generate a slightly smaller amount of heat per unit time than in the fourth process, and the fourth heaters 144 may generate a slightly larger amount of heat per unit time. This may form an upward protruding interface between the silicon melt 72 and the solid phase of the solidified silicon melt 72 when the silicon melt 72 unidirectionally solidifies upward in the mold 141. This unidirectional solidification may allow impurities in the silicon melt 72 to be discharged to near the side wall 141s. This can reduce dislocations and defects resulting from precipitated impurity compounds in a wide portion around the center of the silicon ingot 2 obtained through the unidirectional solidification of the silicon melt 72. The silicon ingot 2 may thus have higher crystallinity. The fourth heaters 144 receiving a slightly increased amount of heat per unit time reduce silicon crystal growth from the side surfaces of the mold 141 and increase the crystal growth of monocrystalline silicon in the positive Z-direction or upward.

In the fifth process, as the silicon melt 72 solidifies unidirectionally, the silicon melt 72 contains more n-type dopant atoms per unit volume (also referred to as n-type dopant concentration) and more p-type dopant atoms per unit volume (also referred to as p-type dopant concentration). The silicon melt 72 may gradually solidify while the electric charge of the p-type dopant is canceling a part of excess electric charge of the n-type dopant. This allows the silicon ingot 2 manufactured through the unidirectional solidification of the silicon melt 72 to contain n-type silicon having an intended resistivity (ρb) in a wider portion.

For the third heater 143 and the fourth heaters 144 made of graphite, a carbon monoxide (CO) gas may be generated from the third heater 143 and the fourth heaters 144 heating the silicon melt 72 in the fifth process. The silicon melt 72 may thus be mixed with carbon monoxide (CO). Carbon monoxide (CO) mixed in the silicon melt 72 is less likely to evaporate. This may increase the number of carbon (C) atoms per unit volume (also referred to as carbon concentration) in the silicon melt 72. The segregation coefficient of carbon (C) in silicon is about 0.07. The number of carbon (C) atoms per unit volume in the silicon melt 72 may thus increase as the silicon melt 72 solidifies unidirectionally in the mold 141.

In the fifth process, the inert gas fed from the second gas feeder 146 toward the second internal space 141i may increase evaporation of oxygen (O) from the silicon melt 72 in the second internal space 141i. This may reduce the number of oxygen (O) atoms per unit volume in the silicon melt 72 in the second internal space 141i. The silicon melt 72 solidifying unidirectionally upward in the mold 141 may thus cause less precipitation of oxides or less formation of silicon oxide films. The silicon ingot 2 obtained through the unidirectional solidification may thus have fewer defects such as oxidation induced stacking fault (OSF) rings.

The amount of inert gas fed from the second gas feeder 146 toward the second internal space 141i per unit time may be increased to further increase the evaporation of oxygen (O) from the silicon melt 72 in the second internal space 141i. This may further reduce the number of oxygen (O) atoms per unit volume in the silicon melt 72 in the second internal space 141i.

In the fifth process, as the silicon melt 72 solidifies unidirectionally in the mold 141, the area of the silicon melt 72 in contact with the mold 141 through the mold release layer 5 decreases. The amount of oxygen (O) mixing into the silicon melt 72 from the mold 141 may thus tend to decrease. This reduces the number of oxygen (O) atoms per unit volume in the silicon melt 72 in the second internal space 141i when the silicon melt 72 solidifies unidirectionally.

In the fifth process, the mold 141 may be rotated about the rotational shaft 145s to reduce the flow velocity of the natural convection in an area of the silicon melt 72 near the inner peripheral surface of the side wall 141s in the mold 141. This may reduce the amount of oxygen (O) mixing into the silicon melt 72 from the mold 141. This may reduce the number of oxygen (O) atoms per unit volume in the silicon melt 72 in the second internal space 141i. In some embodiments, for example, a magnetic field may be applied to reduce the flow velocity of the natural convection in an area of the silicon melt 72 near the inner peripheral surface of the side wall 141s in the mold 141.

In the fifth process, the increase of the number of carbon (C) atoms per unit volume in the silicon melt 72 may accelerate ionization of the group 13 element as the p-type dopant during the unidirectional solidification of the silicon melt 72. The electric charge of the p-type dopant may thus, for example, efficiently cancel a part of excess electric charge of the n-dopant. This may reduce excess increase of the amount of the group 13 element added to silicon as the p-type dopant. This may also reduce defects such as oxides caused by an unionized group 13 element.

### 1-2-6. Sixth Process

In the sixth process in step Sp6, for example, the silicon ingot 2 obtained through the unidirectional solidification in the fifth process is cooled to room temperature in about several hours. The several hours may be, for example, about four to ten hours. The silicon ingot 2 cooled to room temperature is removed from the mold 141.

### 1-3. Silicon Ingot

The structure of the silicon ingot 2 will be described with reference to FIGs. 14 and 15. In the example in FIGs. 14 and 15, the silicon ingot 2 is a rectangular prism. The silicon ingot 2 may be obtained with the manufacturing method for the silicon ingot 2 using the manufacturing apparatus 1 described above.

As illustrated in FIGs. 14 and 15, the silicon ingot 2 includes, for example, an upper surface 21, a lower surface 22, and side surfaces 23. In the example in FIGs. 14 and 15, the upper surface 21 is a rectangular surface or a square surface facing in the positive Z-direction as the first direction. The lower surface 22 is a rectangular surface or a square surface facing in the negative Z-direction as the fourth direction, which is opposite to the first direction. The side surfaces 23 connect the upper surface 21 and the lower surface 22 and extend in the positive Z-direction. In the example in FIGs. 14 and 15, the side surfaces 23 are four side surfaces extending in the positive Z-direction. The four surfaces define a single hollow prism.

The silicon ingot 2 includes, for example, a central portion 200, a lower portion 201, a peripheral portion 202, and an upper portion 203. In the example in FIGs. 14 and 15, the outer edges of the central portion 200 is indicated by thin two-dot-dash lines. In the example in FIG. 14, the boundaries between the lower portion 201 and the peripheral portion 202 and between the upper portion and the peripheral portion 202 are each indicated by a thin two-dot-dash line.

The central portion 200 is a pseudo-monocrystalline portion resulting from the unidirectional solidification of the silicon melt 72 starting from the main seed crystal 61. The central portion 200 has a crystal structure and a crystal direction based on the main seed crystal 61. The central portion 200 is a pseudo-monocrystalline portion of n-type silicon. In the example in FIGs. 14 and 15, the central portion 200 is a rectangular prism located substantially at the center of the silicon ingot 2.

The lower portion 201 includes a portion corresponding to the main seed crystal 61. The lower portion 201 extends along the lower surface 22 of the silicon ingot 2. In the silicon ingot 2, the lower portion 201 is adjacent to the central portion 200 in the negative Z-direction as the fourth direction from the central portion 200. In the example in FIGs. 14 and 15, the lower portion 201 is a rectangular prism.

The peripheral portion 202 includes a portion corresponding to the elongated seed crystals 62 and a portion of pseudo-monocrystals resulting from the unidirectional solidification of the silicon melt 72 starting from the elongated seed crystals 62. The pseudo-monocrystals have a crystal structure and a crystal direction inherited from the elongated seed crystals 62. The peripheral portion 202 is a hollow prismatic or cylindrical portion of the silicon ingot 2 extending along the side surfaces 23. In the silicon ingot 2, the peripheral portion 202 laterally surrounds the lower portion 201, the central portion 200, and the upper portion 203. In the example of FIGs. 14 and 15, the peripheral portion 202 is a hollow prismatic portion.

The upper portion 203 extends along the upper surface 21 of the silicon ingot 2. The upper portion 203 is a portion in which impurity elements are enriched through the unidirectional solidification of the silicon melt 72. The upper portion 203 includes a p-type silicon portion containing more p-type dopant atoms than n-type dopant atom per unit volume due to the segregation in the unidirectional solidification of the silicon melt 72. In the silicon ingot 2, the upper portion 203 is adjacent to the central portion 200 in the positive Z-direction from the central portion 200. In the example in FIGs. 14 and 15, the upper portion 203 is a rectangular prism.

### 1-4. n-Type Silicon Block

### 1-4-1. Structure of n-Type Silicon Block

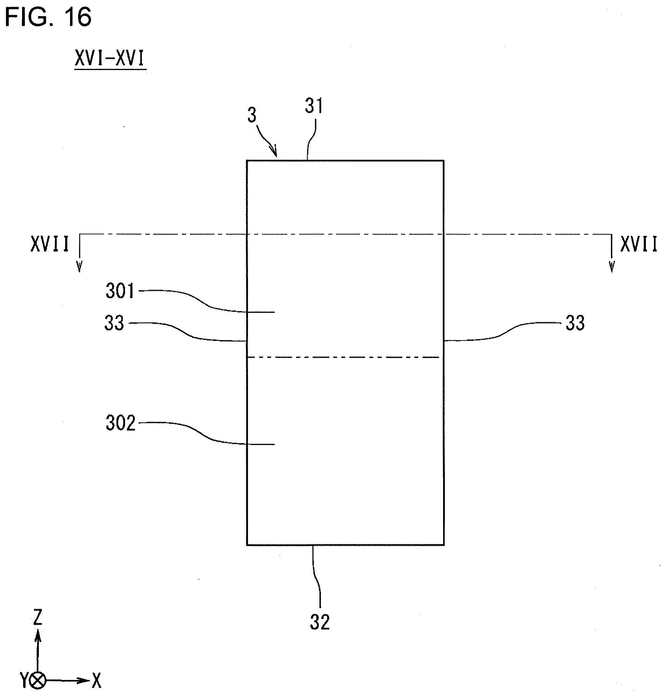

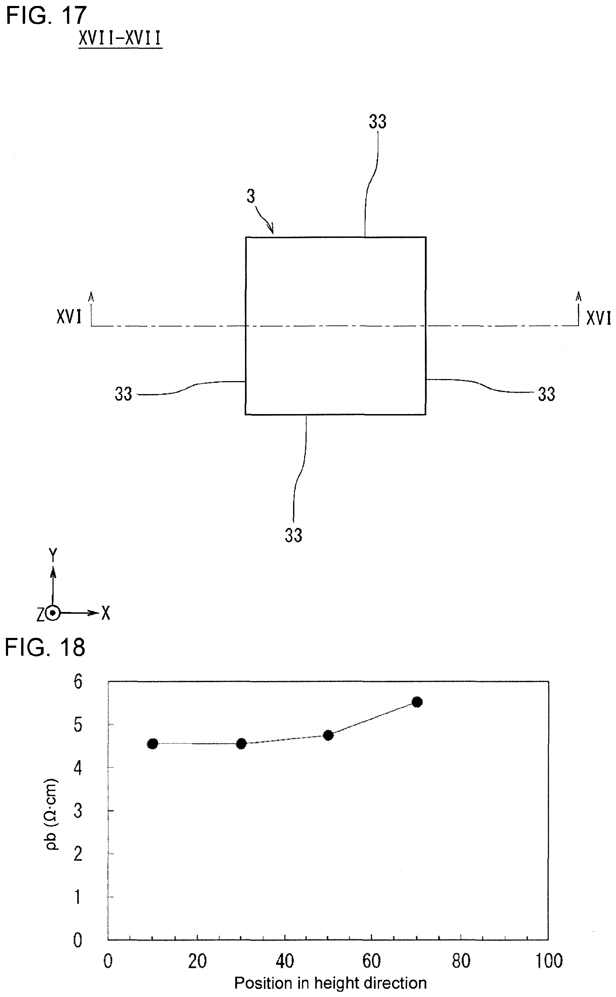

The structure of the n-type silicon block 3 according to the first embodiment will be described with reference to FIGs. 16 and 17. In the example in FIGs. 16 and 17, the n-type silicon block 3 is a rectangular prism. The n-type silicon block 3 may be obtained by cutting the lower portion 201, the peripheral portion 202, and the upper portion 203 from the silicon ingot 2 described above with, for example, a wire saw. In other words, the n-type silicon block 3 corresponds to the central portion 200 of the silicon ingot 2 described above.

As illustrated in the example in FIGs. 16 and 17, the n-type silicon block 3 includes a first surface 31, a second surface 32, and third surfaces 33. In the example in FIGs. 16 and 17, the first surface 31 is a rectangular surface or a square surface (upper surface) facing in the positive Z-direction as the first direction. The second surface 32 is opposite to the first surface 31. In the example in FIGs. 16 and 17, the second surface 32 is a rectangular surface or a square surface (lower surface) facing in the negative Z-direction as a fourth direction, which is opposite to the first direction. The third surfaces 33 connect the first surface 31 and the second surface 32 and extend in the positive Z-direction as the first direction. In the example in FIGs. 16 and 17, the third surfaces 33 are four third surfaces (side surfaces) extending in the positive Z-direction as the first direction. The four surfaces define a single hollow prism. The first surface 31 and the second surface 32 may each have, for example, cut corners.

The n-type silicon block 3 contains a donor (also referred to as the n-type dopant) including a group 15 element, an acceptor (also referred to as the p-type dopant) including a group 13 element, carbon (C), and oxygen (O).

The n-type silicon block 3 contains more atoms of the donor (n-type dopant) including the group 15 element than atoms of the acceptor (p-type dopant) including the group 13 element per unit volume.

The number of atoms of the donor (n-type dopant) including the group 15 element per unit volume in the n-type silicon block 3 is set to, for example, 7.1 × 10¹⁴ to 7 × 10¹⁹ atoms per cubic centimeter (atoms/cm³). The lower limit of 7.1 × 10¹⁴ atoms/cm³ in the numerical range is set based on, for example, the lower limit of the number of atoms of the donor (n-type dopant) including the group 15 element per unit volume detectable using the resistivity measured by the four-point probe method or the eddy current method. The upper limit of 7 × 10¹⁹ atoms/cm³ in the numerical range is set based on, for example, the upper limit of the number of atoms of antimony (Sb) that can mix into silicon in solid state per unit volume. Antimony (Sb) has the minimum upper limit of the number of atoms that can mix into silicon in solid state per unit volume among phosphorus (P), arsenic (As), and antimony (Sb). In some embodiments, the number of atoms of the donor (n-type dopant) including the group 15 element per unit volume in the n-type silicon block 3 may range from, for example, 1.1 × 10¹⁵ to 1.6 × 10¹⁶ atoms/cm³. This numerical range is set based on, for example, the resistivity of 0.4 to 4.5 Ω·cm of silicon substrates that maintain the quality of solar cell elements and the typical relationship between the resistivity of silicon and the density of the n-type dopant.

The number of atoms of the acceptor (p-type dopant) including the group 13 element per unit volume in the n-type silicon block 3 is set to, for example, 1.2 × 10¹⁵ to 4 × 10¹⁷ atoms/cm³. The lower limit of 1.2 × 10¹⁵ atoms/cm³ in the numerical range is set based on, for example, the lower limit of the number of atoms of the acceptor (p-type dopant) including the group 13 element per unit volume detectable using the resistivity measured by the four-point probe method or the eddy current method. The upper limit of 4 × 10¹⁷ atoms/cm³ in the numerical range is set based on, for example, the upper limit of the number of atoms of indium (In) that can mix into silicon in solid state per unit volume. Indium (In) has the minimum upper limit of the number of atoms that can mix into silicon in solid state per unit volume among aluminum (Al), gallium (Ga), and indium (In). In some embodiments, the number of atoms of the acceptor (p-type dopant) including the group 13 element per unit volume in the n-type silicon block 3 may range from, for example, 3 × 10¹⁵ to 5.5 × 10¹⁶ atoms/cm³. This numerical range is set based on, for example, the resistivity of 0.4 to 4.5 Ω·cm of silicon substrates that maintain the quality of solar cell elements and the typical relationship between the resistivity of silicon and the density of the p-type dopant.

In the n-type silicon block 3, the donor (n-type dopant) including the group 15 element has a greater segregation coefficient in silicon than the acceptor (p-type dopant) including the group 13 element. In the n-type silicon block 3, for example, the donor (n-type dopant) including the group 15 element includes at least one element selected from the group consisting of phosphorus (P), arsenic (As), and antimony (Sb). In the n-type silicon block 3, for example, the acceptor (p-type dopant) including the group 13 element includes at least one element selected from the group consisting of aluminum (Al), gallium (Ga), and indium (In).

In the n-type silicon block 3, the number of oxygen (O) atoms per unit volume is set to, for example, 5 × 10¹⁵ to 2.7 × 10¹⁸ atoms/cm³. The lower limit of 5 × 10¹⁵ atom/cm³ in the numerical range is set based on, for example, the lower limit of the number of oxygen (O) atoms per unit volume detectable by secondary-ion mass spectrometry (SIMS) or Fourier-transform infrared spectroscopy (FTIR). The upper limit of 2.7 × 10¹⁸ atoms/cm³ in the numerical range is set based on, for example, the upper limit of the number of oxygen (O) atoms that can mix into silicon in solid state per unit volume. In some embodiments, the number of oxygen (O) atoms per unit volume in the n-type silicon block 3 may range from, for example, 1 × 10¹⁶ to 1 × 10¹⁸ atoms/cm³. The lower limit of 1 × 10¹⁶ atoms/cm³ in the numerical range is set to, for example, reduce breakage and warpage of the n-type silicon substrate 4. The upper limit of 1 × 10¹⁸ atoms/cm³ in the numerical range is set to, for example, reduce a decrease in the output of the solar cell element using the n-type silicon substrate 4.

The number of carbon (C) atoms per unit volume in the n-type silicon block 3 is set to, for example, 5 × 10¹⁵ to 9 × 10¹⁷ atoms/cm³. The lower limit of 5 × 10¹⁵ atoms/cm³ in the numerical range is set based on, for example, the lower limit of the number of carbon (C) atoms per unit volume detectable by SIMS or FTIR. The upper limit of 9 × 10¹⁸ atoms/cm³ in the numerical range is set based on, for example, the upper limit of the number of carbon (C) atoms that can mix into silicon in solid state per unit volume.

The resistivity (ρb) of the n-type silicon block 3 is set to, for example, 0.01 Ω·cm to 10 kiloohm centimeters (kQ.cm). The lower limit of 0.01 Ω·cm in the numerical range is set based on, for example, the lower limit of the resistivity detectable by the four-point probe method or the eddy current method. The upper limit of 10 kΩ·cm in the numerical range is set based on, for example, the upper limit of the resistivity detectable by the four-point probe method or the eddy current method. The resistivity (ρb) of the n-type silicon block 3 may range from, for example, 0.4 to 4.5 Ω·cm. The numerical range of the resistivity (ρb) is set based on, for example, the numerical range of the resistivity of silicon substrates that maintain the quality of solar cell elements.

The n-type silicon block 3 includes a first portion 301 and a second portion 302. The first portion 301 is adjacent to the first surface 31 as the upper surface of the n-type silicon block 3. The second portion 302 is adjacent to the second surface 32 as the lower surface of the n-type silicon block 3. In other words, the second portion 302 and the first portion 301 are aligned in the positive Z-direction as the first direction. In FIG. 16, the thin two-dot-dash line indicates an example boundary between the first portion 301 and the second portion 302.

The first portion 301 includes more carbon (C) atoms than oxygen (O) atoms per unit volume. The second portion 302 includes fewer carbon (C) atoms than or the same number of carbon (C) atoms as oxygen (O) atoms per unit volume. In the first portion 301, the carriers resulting from excitation with, for example, light illumination take a longer time (lifetime) to recombine than in the second portion 302. The first portion 301 may thus improve the quality of the n-type silicon block 3. When the first portion 301 is a monocrystalline portion, the n-type silicon block 3 including the first portion 301 may have higher quality.

The n-type silicon block 3 may be obtained by, for example, cutting off the second portion 302 of the n-type silicon block 3 with, for example, a wire saw. In this case, the n-type silicon block 3 may correspond to the first portion 301. In other words, the n-type silicon block 3 may be a block including the first portion 301 but not including the second portion 302.

### 1-4-2. Specific Example

An n-type silicon block 3 manufactured from a silicon ingot 2 according to one embodiment and including the silicon ingot 2 manufactured using the manufacturing apparatus 1 will be described.

In this example, the mold 141 includes a bottom 141b with a square surface adjacent to the second internal space 141i measuring 381 mm on each side, a square second upper opening 141o measuring 390 mm on each side, and the second internal space 141i having a length (height) of 414 mm in the positive Z-direction. The mold release layer 5 is formed by applying slurry of silicon nitride and silicon oxide to the inner wall surface of the mold 141.

The upper surface and the lower surface of the main seed crystal 61 placed on the bottom 141b of the mold 141 are rectangular surfaces each measuring 220 mm on the sides in X-direction and 300 mm on the sides in Y-direction. The main seed crystal 61 on the bottom 141b of the mold 141 has a thickness of 20 mm in the positive Z-direction. Each elongated seed crystal 62 has a length (width) of 10 mm on its shorter side. Seven elongated seed crystals 62 are placed between the main seed crystal 61 and the side wall 141s in the negative X-direction from the main seed crystal 61. Seven elongated seed crystals 62 are placed between the main seed crystal 61 and the side wall 141s in the positive X-direction from the main seed crystal 61. Three elongated seed crystals 62 are placed between the main seed crystal 61 and the side wall 141s in the negative Y-direction from the main seed crystal 61. Three elongated seed crystals 62 are located between the main seed crystal 61 and the side wall 141s in the positive Y-direction from the main seed crystal 61.

Phosphorus (P) as an n-type dopant and gallium (Ga) as a p-type dopant are added to the silicon lumps 71. More specifically, phosphorus (P) as an n-type dopant is added to per unit volume of the silicon lumps 71 in an amount of about 7.26 × 10¹⁵ atoms/cm³. In other words, phosphorus (P) as an n-type dopant is added to per unit volume of the silicon lumps 71 in an amount of substance (number of moles) of about 1.21 × 10⁻⁸ mol/cm³. Gallium (Ga) as a p-type dopant is added to per unit volume of the silicon lumps 71 in an amount of about 1.85 × 10¹⁷ atoms/cm³. In other words, gallium (Ga) as a p-type dopant is added to per unit volume of the silicon lumps 71 in an amount of substance (number of moles) of about 3.07 × 10⁻⁷ mol/cm³.

The silicon ingot 2 in the specific example is obtained through the unidirectional solidification of the silicon melt 72. The silicon ingot 2 is a rectangular prism including a square lower surface 22 measuring 381 mm on each side and 365 mm in the length (height) in the positive Z-direction.

The lower portion 201, the peripheral portion 202, and the upper portion 203 are cut off from the silicon ingot 2 in the specific example using a wire saw. This allows the central portion 200 to be cut out as the n-type silicon block 3 in the specific example. The resultant n-type silicon block 3 according to the example is a rectangular prism including the first surface 31 as a square upper surface measuring about 160 mm on each side, the second surface 32 as a square lower surface measuring about 160 mm on each side, and the four third surfaces 33 as rectangular side surfaces measuring about 306 mm in the length (height) in the positive Z-direction. When the silicon ingot 2 in the specific example is viewed in plan in the negative Z-direction, a portion surrounding the rectangular prismatic central portion 200 at the center with a size of about 160 mm is the peripheral portion 202. A rectangular prismatic portion with a length (height) of 45.5 mm in the positive Z-direction is the lower portion 201. A rectangular prismatic portion with a length (height) of 13.5 mm in the positive Z-direction is the upper portion 203.

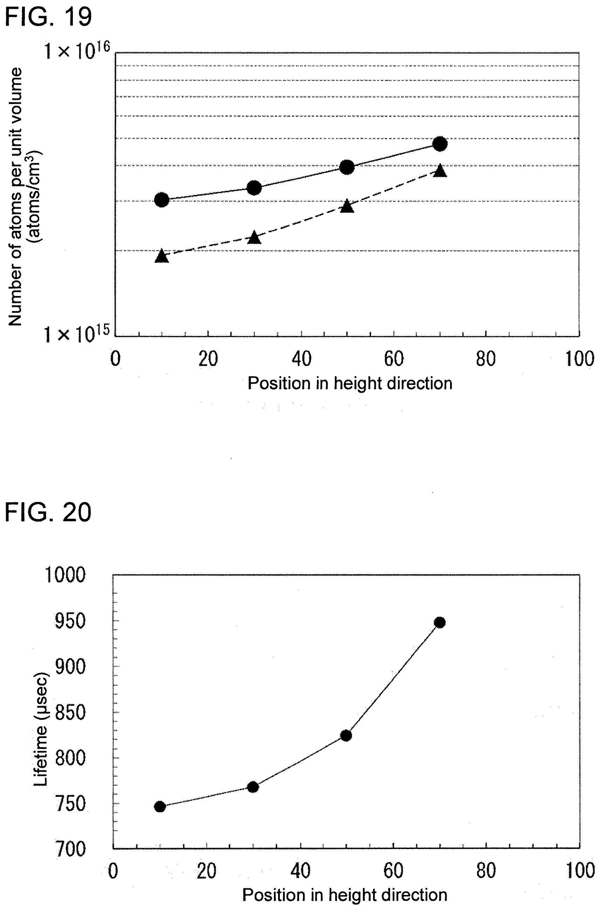

FIG. 18 shows the measurement results of the relationship between the position in the height direction in the silicon ingot 2 in the specific example and the resistivity (ρb). FIG. 19 shows the measurement results of the relationship between the position in the height direction in the silicon ingot 2 in the specific example and the number of atoms of each of phosphorus (P) and gallium (Ga) per unit volume. In FIGs. 18 and 19, the position in the height direction in the silicon ingot 2 in the specific example is the distance (height) from the lower surface 22 in the positive Z-direction, where 0 is a first reference height of the lower surface 22 of the silicon ingot 2 in the specific example, and 100 is a second reference height of the upper surface 21 of the silicon ingot 2 in the specific example.

The resistivity (ρb) shown in FIG. 18 was measured by measuring the electric resistance between the front surface and the back surface of a thin plate obtained by slicing, with a wire saw, the n-type silicon block 3 in the specific example along an XY plane (horizontal plane). The n-type silicon block 3 corresponds to the lower portion 201 or the central portion 200 of the silicon ingot 2 in the specific example. FIG. 18 shows the resistivity (ρb) plotted with solid circles at the positions 10, 30, 50, and 70 in the height direction in the silicon ingot 2 in the specific example.

The number of atoms of each of phosphorus (P) and gallium (Ga) per unit volume shown in FIG. 19 was measured by SIMS. The measurement by SIMS was performed on a thin-plate sample obtained by slicing, with a wire saw, the n-type silicon block 3 in the specific example along an XY plane (horizontal plane). The n-type silicon block 3 corresponds to the lower portion 201 or the central portion 200 of the silicon ingot 2 in the specific example. The obtained thin-plate sample was polished and washed before being measured. FIG. 19 shows the number of phosphorus (P) atoms per unit volume plotted with solid circles and the number of gallium (Ga) atoms per unit volume plotted with solid triangles at the positions 10, 30, 50, and 70 in the height direction in the silicon ingot 2 in the specific example.

FIG. 18 indicates that the silicon ingot 2 in the specific example has a small change in the resistivity (ρb) in a wide portion in the height direction parallel to the positive Z-direction. FIG. 19 indicates that the silicon ingot 2 in the specific example includes more phosphorus (P) atoms as an n-type dopant than Gallium (Ga) atoms as a p-type dopant per unit volume in a wide portion in the height direction parallel to the positive Z-direction, indicating that an n-type silicon is obtained.

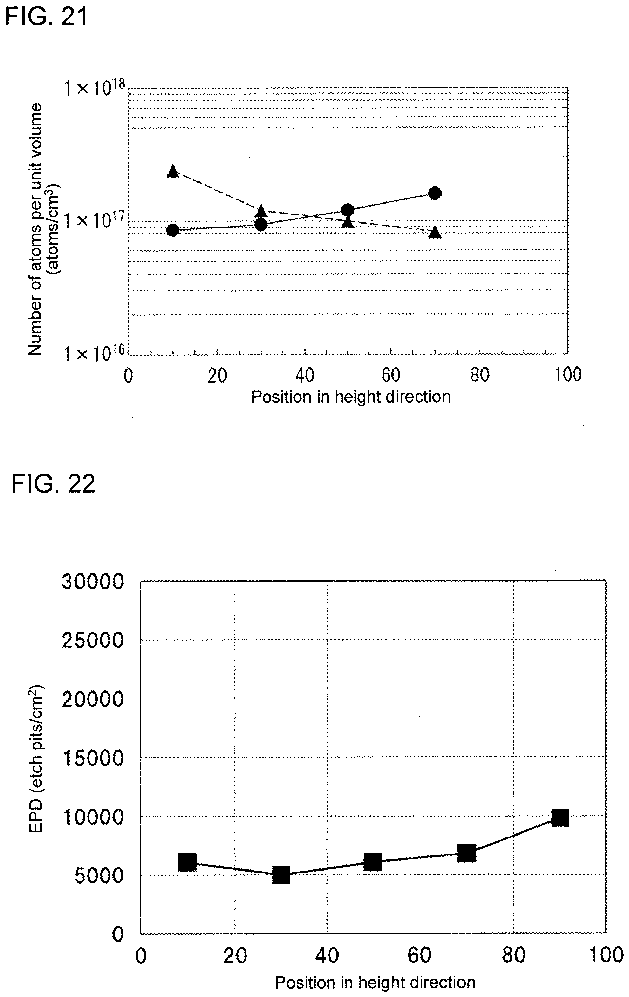

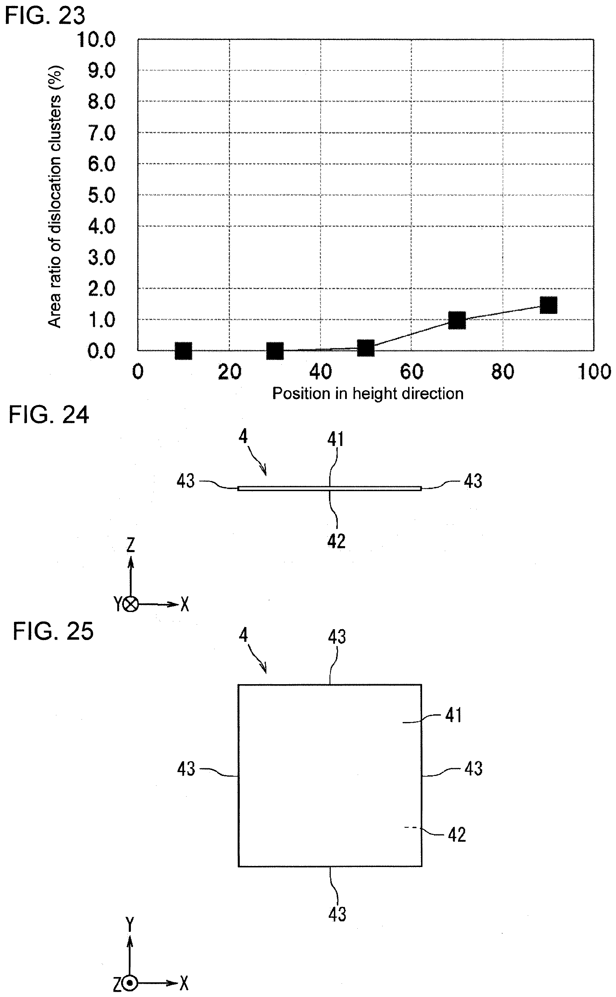

FIG. 20 shows the measurement results of the relationship between the position in the height direction in the n-type silicon block 3 in the specific example and the lifetime. FIG. 21 shows the measurement results of the relationship between the position in the height direction in the n-type silicon block 3 in the specific example and the number of atoms of each of carbon (C) and oxygen (O) per unit volume. FIG. 22 shows the measurement results of the relationship between the position in the height direction in the n-type silicon block 3 in the specific example and the etch pit density (EPD) resulting from anisotropic etching with predetermined Dash etching. FIG. 23 shows the measurement results of the relationship between the position in the height direction in the n-type silicon block 3 in the specific example and the ratio of the area used by dislocation clusters. In FIGs. 20 to 23, the position in the height direction in the n-type silicon block 3 is the distance (height) from the second surface 32 in the position Z-direction, where 0 is a first reference height of the second surface 32 as the lower surface, and 100 is a second reference height of the first surface 31 as the upper surface.

The lifetime shown in FIG. 20 indicates the time taken for the carriers resulting from excitation with, for example, light illumination to recombine. This lifetime was measured by quasi-steady state photoconductance (QSSPC). The lifetime measurement by QSSPC was performed on a thin-plate sample obtained by slicing, with a wire saw, the n-type silicon block 3 in the specific example along an XY plane (horizontal plane). The obtained thin-plate sample was treated in a predetermined manner before being measured. The predetermined treatment includes removing the surface layer by etching using potassium hydroxide (KOH), gettering, and passivation performed in this order. The lifetime measurement by QSSPC was performed at 10 or more points across the entire surface of the thin-plate sample. The average of the measured values of the 10 or more points was used as the measurement result at one position in the height direction in the n-type silicon block 3 in the specific example. FIG. 20 shows the measurement results of the lifetime plotted with solid circles at the positions 10, 30, 50, and 70 in the height direction in the n-type silicon block 3 in the specific example.

The numbers of atoms of carbon (C) and oxygen (O) per unit volume shown in FIG. 21 were measured by SIMS. The measurement by SIMS was performed on a thin-plate sample obtained by slicing, with a wire saw, the n-type silicon blocks 3 in the specific example along an XY plane (horizontal plane). The thin-plate sample was polished and washed before being measured. FIG. 21 shows the number of carbon (C) atoms per unit volume plotted with solid circles and the number of oxygen (O) atoms per unit volume plotted with solid triangles at the positions 10, 30, 50, and 70 in the height direction in the n-type silicon block 3 in the specific example.

The EPD shown in FIG. 22 was measured by counting the number of etch pits resulting from anisotropic etching with Dash etching performed on a thin-plate sample obtained by slicing, with a wire saw, the n-type silicon block 3 in the specific example along an XY plane (horizontal plane). In Dash etching, a chemical solution being a mixture of acetic acid, hydrofluoric acid, and nitric acid was used. The etch pits were determined to occur at positions with defects on the plate surface of the sample. The EPD was measured by counting the number of etch pits in 13 fields of view equally spaced along one diagonal of the plate surface of a thin-plate sample. The total number of etch pits in the 13 fields of view was divided by the total value of the areas of the 13 fields of view. The resultant value was used as the EPD at a position in the height direction in the n-type silicon block 3 in the specific example. FIG. 22 shows the EPD plotted with slid squares at the positions 10, 30, 50, 70, and 90 in the height direction in the n-type silicon block 3 in the specific example.

The ratio of the area used by the dislocation clusters shown in FIG. 23 is the ratio of the area (area ratio) used by the dislocation clusters on the surface of one thin-plate sample obtained by slicing, with a wire saw, the n-type silicon block 3 in the specific example along an XY plane (horizontal plane). The area of the dislocation clusters appears as clouding after Dash etching. FIG. 23 shows the area ratio of the dislocation clusters plotted with solid squares at the positions 10, 30, 50, 70, and 90 in the height direction in the n-type silicon block 3 in the specific example.

As shown in FIG. 20, the measurement results indicate that the n-type silicon block 3 in the specific example has a notably longer lifetime at positions 50 and 70 in the height direction than at positions 10 and 30 in the height direction. In other words, the measurement results indicate that the n-type silicon block 3 in the specific example has a notably longer lifetime at positions 50 or higher in the height direction than at positions lower than 50 in the height direction.

As shown in FIG. 21, the n-type silicon block 3 in the specific example tends to contain more carbon (C) atoms and fewer oxygen (O) atoms per unit volume at larger distances from the second surface 32 and smaller distances to the first surface 31. More specifically, the measurement results indicate that the n-type silicon block 3 in the specific example contains more oxygen (O) atoms than carbon (C) atoms per unit volume at positions 10 and 30 in the height direction. In contrast, the n-type silicon block 3 contains more carbon (C) atoms than oxygen (O) atoms per unit volume at positions 50 and 70 in the height direction. In other words, the measurement results indicate that the n-type silicon block 3 in the specific example contains more carbon (C) atoms than oxygen (O) atoms per unit volume at positions 50 or higher in the height direction. The first portion 301 described above corresponds to the portion of the n-type silicon block 3 in the specific example that contains more carbon (C) atoms than oxygen (O) atoms per unit volume. The second portion 302 described above corresponds to the portion of the n-type silicon block 3 in the specific example that contains fewer carbon (C) atoms than or the same number of carbon (C) atoms as oxygen (O) atoms per unit volume.

As shown in FIGs. 22 and 23, the measurement results indicate that the n-type silicon block 3 in the specific example has a gently increasing EPD and a gently increasing area ratio of dislocation clusters at a larger distance from the second surface 32 in the height direction.

This indicates that the n-type silicon block 3 in the specific example has a notably longer lifetime when the n-type silicon block 3 contains more carbon (C) atoms than oxygen (O) atoms per unit volume. In other words, the n-type silicon block 3 in the specific example has a notably longer lifetime in the portion corresponding to the first portion 301 described above than in the portion corresponding to the second portion 302 described above.

Some research papers report that elements in group 13 as a p-type dopant use less energy (also referred to as ionization energy) to be ionized when being contained with carbon (C) than when being contained alone (refer to, for example, K. Inoue; T. Taishi; Y. Tokumoto; K. Kutsukake; Y. Ohno; T. Ohsawa; R. Gotoh; I. Yonenaga, Czochralski Growth of Heavily Indium-Doped Si Crystals and Co-doping Effects of Group-IV Elements. Journal of Crystal Growth 2014, 393, 45-48). This suggests that more carbon (C) atoms per unit volume in the n-type silicon block 3 accelerate ionization of the group 13 element as a p-type dopant. Thus, the electric charge of the p-type dopant can cancel a part of excess electric charge of the n-type dopant without, for example, excess increase in the number of p-type dopant atoms per unit volume in the silicon block 3. This may also reduce defects such as oxides caused by a nonionized group 13 element, thus notably lengthening the lifetime of the n-type silicon block 3 in the specific example with the increase in the number of carbon (C) atoms per volume.

The n-type silicon block 3 has fewer defects such as OSF rings seemingly resulting from the decrease in the number of oxygen (O) atoms per unit volume. This may also allow the n-type silicon block 3 in the specific example to have a longer lifetime with the decrease in the number of oxygen (O) atoms per unit volume.

### 1-5. n-Type Silicon Substrate

The structure of the n-type silicon substrate 4 according to the first embodiment will be described with reference to FIGs. 24 and 25. In the example in FIGs. 24 and 25, the n-type silicon substrate 4 is a rectangular plate including front and back surfaces. The n-type silicon substrate 4 may be obtained by, for example, slicing the first portion 301 of the n-type silicon block 3 along an XY plane. For example, the first portion 301 of the n-type silicon block 3 may be sliced along an XY plane parallel to each of the first surface 31 and the second surface 32 at predetermined intervals in the positive Z-direction as the first direction. In this example, a wire saw is used to slice the first portion 301 of the n-type silicon block 3 into n-type silicon substrates 4 each measuring about 100 to 500 micrometers (µm) in thickness and including a square plate surface measuring about 140 to 160 mm on each side. The surface layer of the n-type silicon substrate 4 may include a damaged layer resulting from the cutting of the n-type silicon block 3. The damaged layer may be removed by etching using, for example, a sodium hydroxide solution.

As shown in FIGs. 24 and 25, the n-type silicon substrate 4 includes, for example, a fourth surface 41, a fifth surface 42, and sixth surfaces 43. The n-type silicon substrate 4 is a flat plate. In the example in FIGs. 24 and 25, the fourth surface 41 is a rectangular surface or a square surface (also referred to as an upper surface) facing in the positive Z-direction as the first direction. The fifth surface 42 is opposite to the fourth surface 41 in the positive Z-direction as the first direction. In the example in FIGs. 24 and 25, the fifth surface 42 is a rectangular surface or a square surface (also referred to as a lower surface) facing in the negative Z-direction as the fourth direction, which is opposite to the first direction. The sixth surfaces 43 connect the fourth surface 41 and the fifth surface 42. In the example in FIGs. 24 and 25, the sixth surfaces 43 are outer peripheral surfaces along the four sides of each of the fourth surface 41 and the fifth surface 42. The fourth surface 41 and the fifth surface 42 may each have cut corners.

The n-type silicon substrate 4 contains a donor (n-type dopant) including a group 15 element, an acceptor (p-type dopant) including a group 13 element, carbon (C), and oxygen (O).

The n-type silicon substrate 4 contains more atoms of the donor (n-type dopant) including the group 15 element than atoms of the acceptor (p-type dopant) including a group 13 element per unit volume.

The number of atoms of the donor (n-type dopant) including the group 15 element per unit volume in the n-type silicon substrate 4 is set to, for example, 7.1 × 10¹⁴ to 7 × 10¹⁹ atoms/cm³, in the same manner as in the n-type silicon block 3. In some embodiments, the number of atoms of the donor (n-type dopant) including the group 15 element per unit volume in the n-type silicon substrate 4 may range from, for example, 1.1 × 10¹⁵ to 1.6 × 10¹⁶ atoms/cm³, in the same manner as in the n-type silicon block 3. The number of atoms of the acceptor (p-type dopant) including the group 13 element per unit volume in the n-type silicon substrate 4 is set to, for example, 1.2 × 10¹⁵ to 4 × 10¹⁷ atoms/cm³, in the same manner as in the n-type silicon block 3. In some embodiments, the number of atoms of the acceptor (p-type dopant) including the group 13 element per unit volume in the n-type silicon substrate 4 may range from, for example, 3 × 10¹⁵ to 5.5 × 10¹⁶ atoms/cm³, in the same manner as in the n-type silicon block 3.

In the n-type silicon substrate 4, the donor (n-type dopant) including the group 15 element has a greater segregation coefficient in silicon than the acceptor (p-type dopant) including the group 13 element. In the n-type silicon substrate 4, the donor (n-type dopant) including the group 15 element includes, for example, at least one element selected from the group consisting of phosphorus (P), arsenic (As), and antimony (Sb). In the n-type silicon substrate 4, the acceptor (p-type dopant) including the group 13 element includes, for example, at least one element selected from the group consisting of aluminum (Al), gallium (Ga), and indium (In).

The n-type silicon substrate 4 includes more carbon (C) atoms than oxygen (O) atoms per unit volume. The n-type silicon substrate 4 takes a longer time (lifetime) for the carriers resulting from excitation with, for example, light illumination to recombine than an n-type silicon substrate cut out from the second portion 302 of the n-type silicon block 3. This indicates that the n-type silicon substrate 4 has higher quality. When the first portion 301 of the n-type silicon block 3 includes a monocrystalline portion, the n-type silicon substrate 4 includes a monocrystalline portion. The n-type silicon substrate 4 with the monocrystalline portion may have higher quality.

The number of oxygen (O) atoms per unit volume in the n-type silicon substrate 4 is set to, for example, 5 × 10¹⁵ to 2.7 × 10¹⁸ atoms/cm³, in the same manner as in the n-type silicon block 3. In some embodiments, the number of oxygen (O) atoms per unit volume in the n-type silicon substrate 4 may range from, for example, 1 × 10¹⁶ to 1 × 10¹⁸ atoms/cm³, in the same manner as in the n-type silicon block 3. The number of carbon (C) atoms per unit volume in the n-type silicon substrate 4 is set to, for example, 5 × 10¹⁵ to 9 × 10¹⁷ atoms/cm³, in the same manner as in the n-type silicon block 3.

The resistivity (ρb) of the n-type silicon substrate 4 is set to, for example, 0.01 Ω·cm to 10 kΩ·cm, in the same manner as for the n-type silicon block 3. In some embodiments, the resistivity (ρb) of the n-type silicon substrate 4 may range from, for example, 0.4 to 4.5 Ω·cm, in the same manner as for the n-type silicon block 3.

The n-type silicon substrate 4 according to the first embodiment may be used as, for example, a semiconductor substrate included in a solar cell element as a solar cell. The solar cell element may thus have higher quality in, for example, output characteristics.

### 1-6. Overview of First Embodiment

The n-type silicon block 3 according to the first embodiment contains, for example, the donor (n-type dopant) including a group 15 element, the acceptor (p-type dopant) including a group 13 element, carbon (C), and oxygen (O). The n-type silicon block 3 includes more donor (n-type dopant) atoms than acceptor (p-type dopant) atoms per unit volume. The donor (n-type dopant) has a greater segregation coefficient in silicon than the acceptor (p-type dopant). The n-type silicon block 3 includes the first portion 301 including more carbon (C) atoms than oxygen (O) atoms per unit volume. The first portion 301 thus takes a longer time (lifetime) for the carriers resulting from excitation with, for example, light illumination to recombine than the second portion 302 including fewer carbon (C) atoms than or the same number of carbon (C) atoms as oxygen (O) atoms per unit volume in the silicon block 3. The first portion 301 may thus improve the quality of the n-type silicon block 3.

The n-type silicon substrate 4 according to the first embodiment contains, for example, the donor (n-type dopant) including a group 15 element, the acceptor (p-type dopant) including a group 13 element, carbon (C), and oxygen (O). The n-type silicon substrate 4 includes more donor (n-type dopant) atoms than acceptor (p-type dopant) atoms per unit volume. The donor (n-type dopant) has a greater segregation coefficient in silicon than the acceptor (p-type dopant). The n-type silicon substrate 4 contains more carbon (C) atoms than oxygen (O) atoms per unit volume. The n-type silicon substrate 4 may thus take a longer time (lifetime) for the carriers resulting from excitation with, for example, light illumination to recombine. This may improve the quality of the n-type silicon substrate 4.

### 2. Other Embodiments

The present disclosure is not limited to the first embodiment described above and may be changed or varied variously without departing from the spirit and scope of the present disclosure.

### 2-1. Second Embodiment

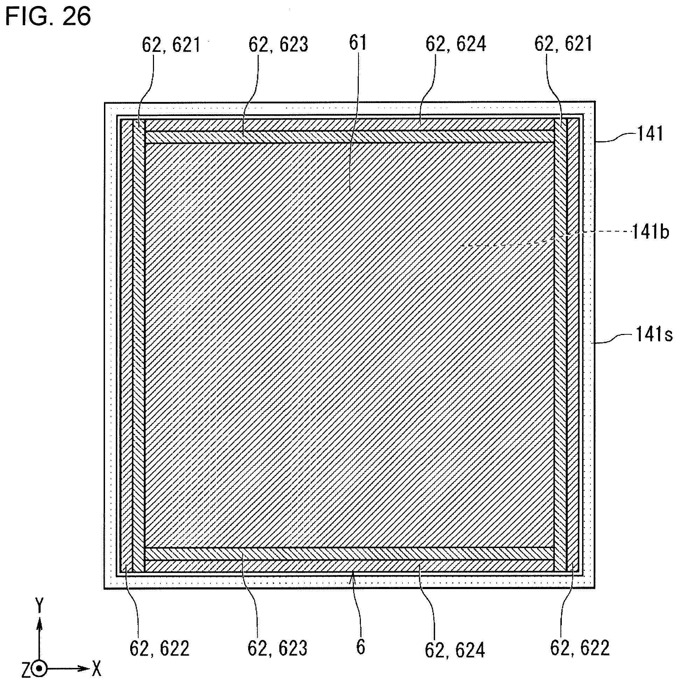

In the first embodiment, the main seed crystal 61 may use a larger area on the bottom 141b of the mold 141, as illustrated in the example in FIG. 26. For example, the upper and lower surfaces of the main seed crystal 61 on the bottom 141b of the mold 141 may be rectangular surfaces each measuring 320 mm or greater on the sides in X-direction and 320 mm or greater on the sides in Y-direction. In the example in FIG. 26, each of the first predetermined number, the second predetermined number, the third predetermined number, and the fourth predetermined number is two.

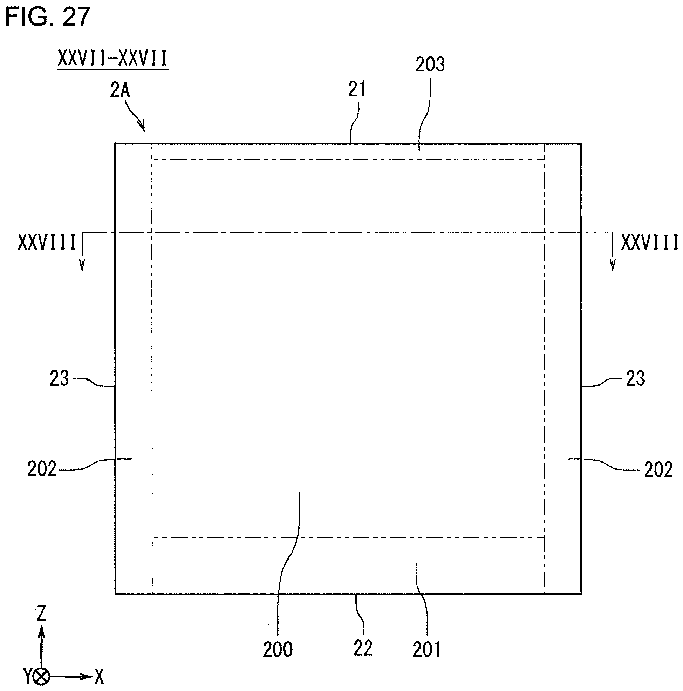

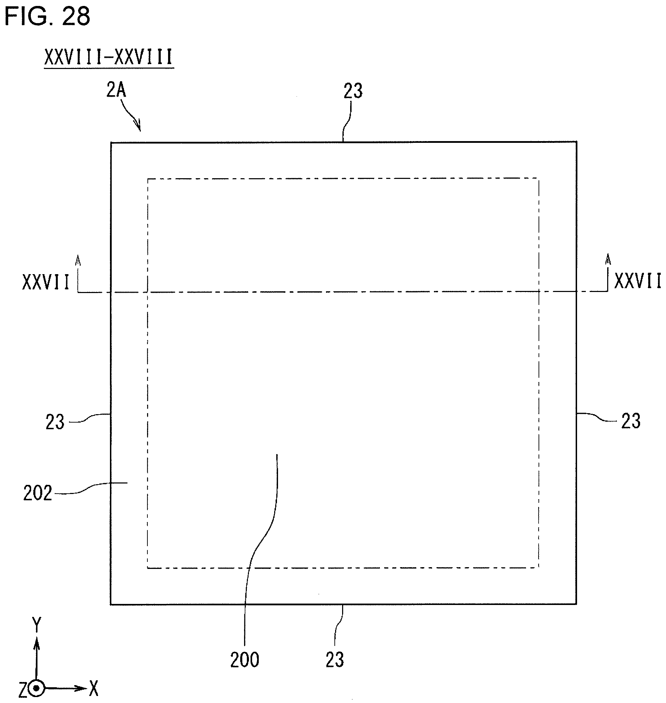

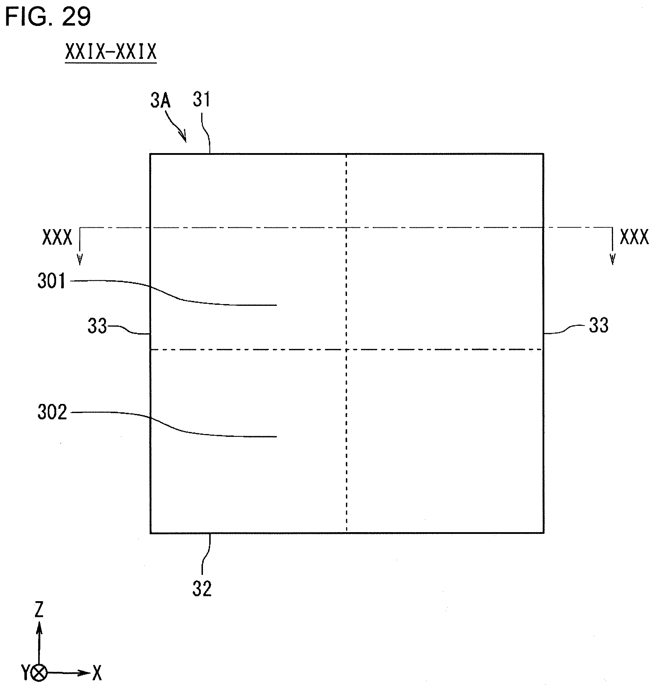

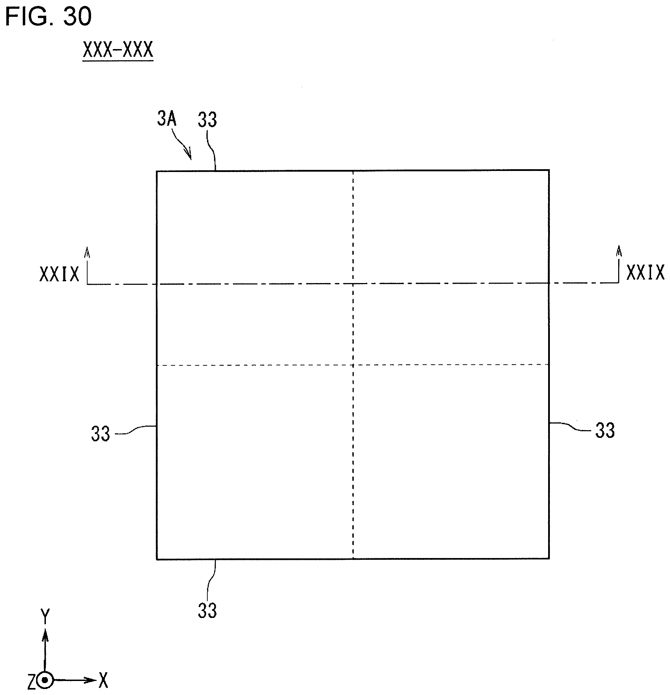

In this example, a silicon ingot 2A according to a second embodiment including an enlarged central portion 200 is obtained as illustrated in FIGs. 27 and 28 based on the silicon ingot 2 according to the first embodiment illustrated in FIGs. 14 and 15. Thus, an n-type silicon block 3A according to the second embodiment with its full portion being enlarged as illustrated in FIGs. 29 and 30 is obtained based on the n-type silicon block 3 according to the first embodiment illustrated in FIGs. 16 and 17. The n-type silicon block 3A may be divided into, using a wire saw or another tool, m1 pieces (m1 is a natural number greater than or equal to 2) in the positive X-direction as the second direction and into m2 pieces (m2 is a natural number greater than or equal to 2) in the positive Y-direction as the third direction to obtain (m1 × m2) n-type silicon blocks. For example, the n-type silicon block 3A may be divided into two equal pieces in the positive X-direction and into two equal pieces in the positive Y-direction along the thin dashed lines in FIGs. 29 and 30 to obtain four n-type silicon blocks. In this case, each of the n-type silicon blocks obtained by dividing the n-type silicon block 3A may be the n-type silicon block 3 illustrated in FIGs. 16 and 17.

### 2-2. Third Embodiment

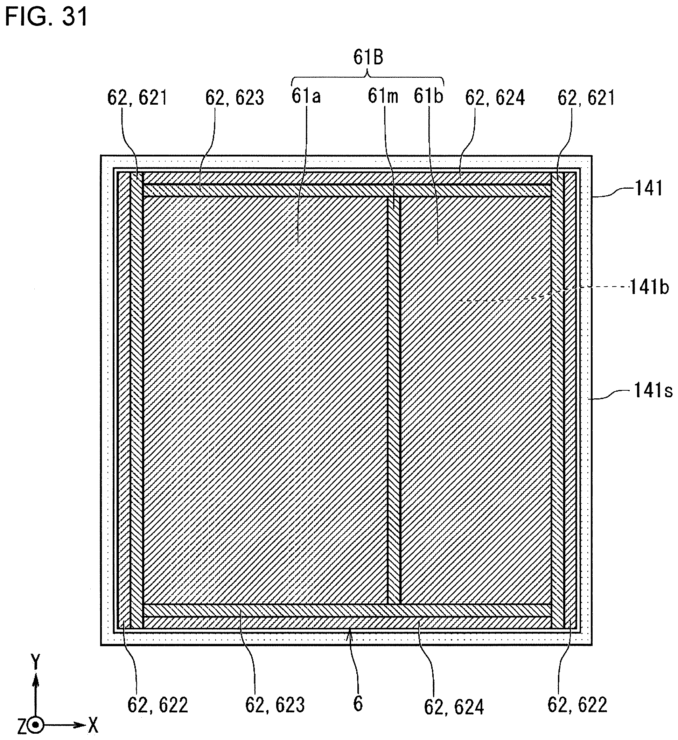

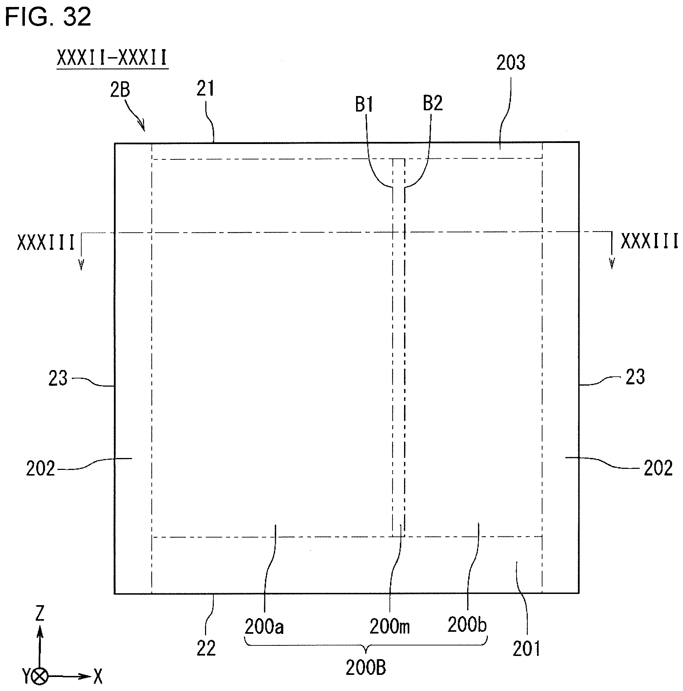

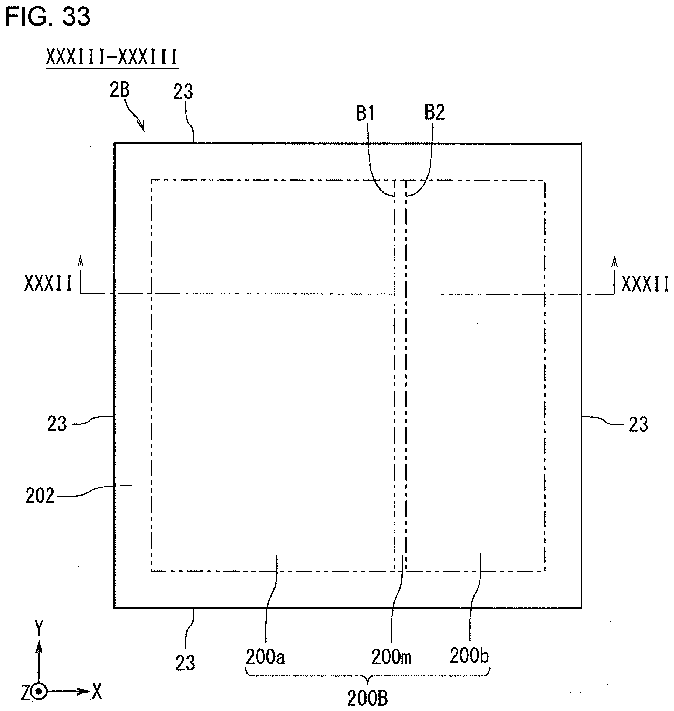

In the second embodiment, the main seed crystal 61 on the bottom 141b of the mold 141 may be replaced with a main seed crystal assembly 61B including multiple seed crystals, as illustrated in the example in FIG. 31. Thus, a silicon ingot 2B according to a third embodiment illustrated in FIGs. 32 and 33 is obtained instead of the silicon ingot 2A according to the second embodiment illustrated in FIGs. 27 and 28. In this case, the upper surface of the bottom 141b of the mold 141 and the bottom and upper surfaces of the silicon ingot 2B can be enlarged.

With mono-like casting, distortions and defects originating from the side wall 141s of the mold 141 tend to occur in the peripheral portion 202 during the manufacture of the silicon ingot 2B. Thus, the peripheral portion 202 and other similar portions of the silicon ingot 2B may be cut off to obtain the n-type silicon block 3B with fewer defects and higher quality in the third embodiment. The n-type silicon block 3B is sliced into n-type silicon substrates 4B with fewer defects and higher quality in the third embodiment. The larger bottom and upper surface areas of the silicon ingot 2B can reduce the proportion of the peripheral portion 202 to be cut off from the silicon ingot 2B. This may improve, for example, the productivity of the n-type silicon block 3B and the n-type silicon substrate 4B.

In the example in FIG. 31, the main seed crystal assembly 61B includes a first main seed crystal 61a, an intermediate seed crystal 61m, and a second main seed crystal 61b. In this example, the first main seed crystal 61a, the intermediate seed crystal 61m, and the second main seed crystal 61b are located on the bottom 141b of the mold 141 adjacent to each other in this order in the positive X-direction as the second direction. In other words, for example, the intermediate seed portion 61m is between the first main seed crystal 61a and the second main seed crystal 61b. The intermediate seed crystal 61m has a smaller width than each of the first main seed crystal 61a and the second main seed crystal 61b in the positive X-direction as the second direction. In other words, each of the first main seed crystal 61a and the second main seed crystal 61b has a larger width than the intermediate seed crystal 61m in the positive X-direction as the second direction.

Each of the first main seed crystal 61a, the intermediate seed crystal 61m, and the second main seed crystal 61b contains monocrystalline silicon. Each of the first main seed crystal 61a, the intermediate seed crystal 61m, and the second main seed crystal 61b is, for example, rectangular and includes a pair of sides extending in X-direction and a pair of sides extending in Y-direction as viewed in plan in the negative Z-direction. In other words, each of the first main seed crystal 61a, the intermediate seed crystal 61m, and the second main seed crystal 61b includes rectangular front and back surfaces. Each of the first main seed crystal 61a, the intermediate seed crystal 61m, and the second main seed crystal 61b may include front and back surfaces that are not rectangular.

Each of the first main seed crystal 61a and the second main seed crystal 61b is, for example, a plate or a block of monocrystalline silicon. The intermediate seed crystal 61m is, for example, one or more rods of monocrystalline silicon. In other words, for example, each of the first main seed crystal 61a, the intermediate seed crystal 61m, and the second main seed crystal 61b contains monocrystalline silicon of the same material. The intermediate seed crystal 61m may include one silicon monocrystal, two or more silicon monocrystals aligned in the positive Y-direction, or two or more silicon monocrystals aligned in the positive X-direction. The distance between the two or more silicon monocrystals may be, for example, about 0 to 3 mm or about 0 to 1 mm.

The first main seed crystal 61a and the intermediate seed crystal 61m have a sixth rotation angle relationship between their silicon monocrystals about an imaginary axis parallel to the positive Z-direction. The intermediate seed crystal 61m and the second main seed crystal 61b have a seventh rotation angle relationship between their silicon monocrystals about an imaginary axis parallel to the positive Z-direction.

In this case, in step Sp22 described above, the main seed crystal assembly 61B is placed to cause each of the sixth rotation angle relationship and the seventh rotation angle relationship to be, for example, the angular relationship in the rotation direction of silicon monocrystals corresponding to a coincidence boundary. The sixth rotation angle relationship between the first main seed crystal 61a and the intermediate seed crystal 61m may be set to, for example, 45 degrees corresponding to a Σ29 coincidence boundary. In this case, for example, the crystal direction of the first main seed crystal 61a in the positive X-direction has the Miller indices of <100>. The crystal direction of the intermediate seed crystal 61m in the positive X-direction has the Miller indices of <110>. The seventh rotation angle relationship between the intermediate seed crystal 61m and the second main seed crystal 61b may be set to, for example, 45 degrees corresponding to a Σ29 coincidence boundary. In this case, for example, the crystal direction of the intermediate seed crystal 61m in the positive X-direction has the Miller indices of <110>. The crystal direction of the second main seed crystal 61b in the positive X-direction has the Miller indices of <100>.

In this case, in the fifth process in step Sp5 described above, a pseudo-monocrystal grows from each of the first main seed crystal 61a, the intermediate seed crystal 61m, and the second main seed crystal 61b. This allows, for example, a grain boundary (functional grain boundary) including a coincidence boundary to form at the boundary between the pseudo-monocrystal grown from the first main seed crystal 61a and the pseudo-monocrystal grown from the intermediate seed crystal 61m based on the sixth rotation angle relationship inherited from the first main seed crystal 61a and the intermediate seed crystal 61m. In other words, a coincidence boundary may form above the boundary between the first main seed crystal 61a and the intermediate seed crystal 61m. For example, a grain boundary (functional grain boundary) including a coincidence boundary may form at the boundary between the pseudo-monocrystal grown from the intermediate seed crystal 61m and the pseudo-monocrystal grown from the second main seed crystal 61b based on the seventh rotation angle relationship inherited from the intermediate seed crystal 61m and the second main seed crystal 61b. In other words, a coincidence boundary may form above the boundary between the intermediate seed portion 61m and the second main seed crystal 61b.

The distortions with the unidirectional solidification of the silicon melt 72 may thus be reduced when the coincidence boundaries form. When the silicon melt 72 solidifies unidirectionally, dislocations may occur between the first main seed crystal 61a and the second main seed crystal 61b. The dislocations may disappear at the two functional grain boundaries and may be confined into the portion of the pseudo-monocrystal between the two functional grain boundaries. The intermediate seed crystal 61m has a smaller width than each of the first main seed crystal 61a and the second main seed crystal 61b in the positive X-direction. The silicon ingot 2B may thus have fewer defects. This may reduce defects in each of the n-type silicon block 3B and the n-type silicon substrate 4B according to the third embodiment obtained from the silicon ingot 2B. In other words, each of the n-type silicon block 3B and the n-type silicon substrate 4B may have higher quality.

### Silicon Ingot

As illustrated in the example in FIGs. 32 and 33, the silicon ingot 2B according to the third embodiment has a structure based on the silicon ingot 2A according to the second embodiment. The silicon ingot 2B includes, in place of the central portion 200, a central portion assembly 200B including a first central portion 200a, a second central portion 200b, and an intermediate portion 200m. In FIGs. 32 and 33, example outer edges of the central portion assembly 200B are indicated by thin two-dot-dash lines. In FIG. 32, example boundaries between the lower portion 201 and the peripheral portion 202 and between the upper portion and the peripheral portion 202 are indicated by thin two-dot-dash lines. The first central portion 200a is a pseudo-monocrystalline portion resulting from the unidirectional solidification of the silicon melt 72 starting from the first main seed crystal 61a. The first central portion 200a has a crystal structure and a crystal direction inherited from the first main seed crystal 61a. The second central portion 200b is a pseudo-monocrystalline portion resulting from the unidirectional solidification of the silicon melt 72 starting from the second main seed crystal 61b. The second central portion 200b has a crystal structure and a crystal direction inherited from the second main seed crystal 61b. The intermediate portion 200m is a pseudo-monocrystalline portion resulting from the unidirectional solidification of the silicon melt 72 starting from the intermediate seed crystal 61m. The intermediate portion 200m has a crystal structure and a crystal direction inherited from the intermediate seed crystal 61m.

The silicon ingot 2 includes a boundary (also referred to as a first boundary) B1 between the first central portion 200a and the intermediate portion 200m and a boundary (also referred to as a second boundary) B2 between the intermediate portion 200m and the second central portion 200b. In FIGs. 32 and 33, each of the first boundary B1 and the second boundary B2 is indicated by a thin two-dot-dash line. Each of the first boundary B1 and the second boundary B2 includes a coincidence boundary. The surface of each of the first central portion 200a, the second central portion 200b, and the intermediate portion 200m perpendicular to the positive Z-direction as the first direction may have the Miller indices of (100). In other words, the crystal directions of one or more pseudo-monocrystals included in each of the first central portion 200a, the second central portion 200b, and the intermediate portion 200m parallel to the positive Z-direction as the first direction may have the Miller indices of <100>. In this case, for example, the coincidence boundary includes one of a Σ5 coincidence boundary, a Σ13 coincidence boundary, a Σ17 coincidence boundary, a Σ25 coincidence boundary, or a Σ29 coincidence boundary.

### N-Type Silicon Block

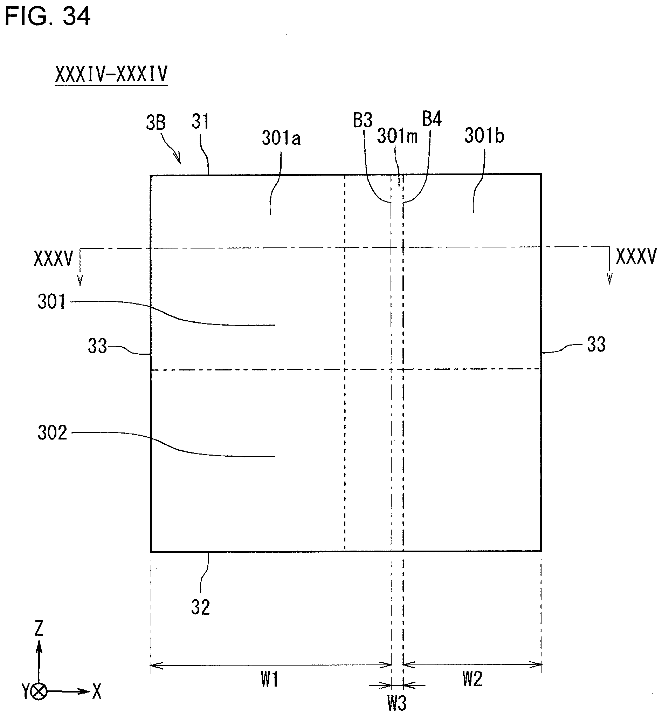

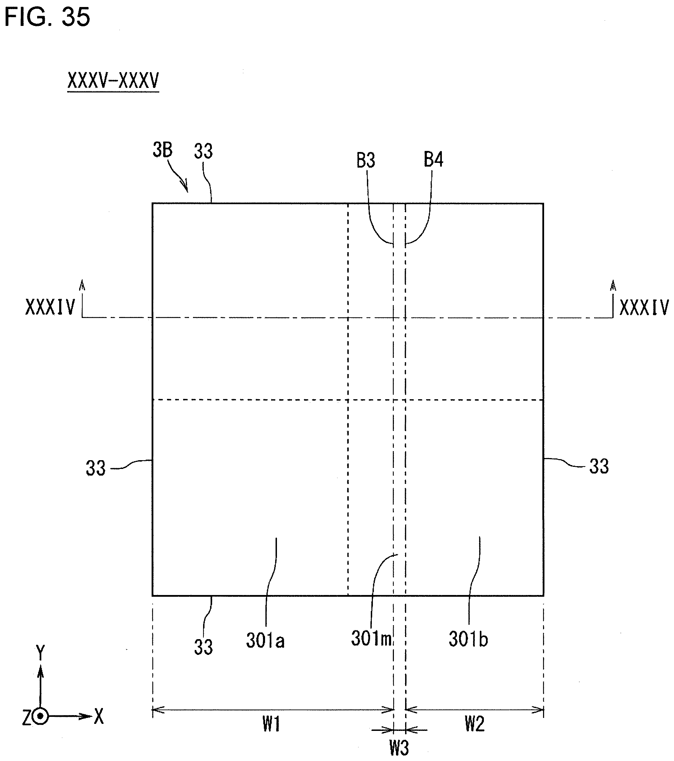

The n-type silicon block 3B according to the third embodiment with an example structure will be described with reference to FIGs. 34 and 35. The n-type silicon block 3B according to the third embodiment corresponds to the central portion assembly 200B in the silicon ingot 2B described above. As illustrated in the example in FIGs. 34 and 35, the n-type silicon block 3B includes a first surface 31, a second surface 32, and third surfaces 33, in the same manner as the n-type silicon blocks 3 and 3A according to the first embodiment and the second embodiment. The n-type silicon block 3B includes a first portion 301 and a second portion 302, in the same manner as the n-type silicon blocks 3 and 3A according to the first embodiment and the second embodiment. In FIG. 34, the boundary between the first portion 301 and the second portion 302 is indicated by a thin two-dot-dash line.

The first portion 301 includes a first pseudo-monocrystalline portion 301a, a first intermediate portion 301m, and a second pseudo-monocrystalline portion 301b. The first pseudo-monocrystalline portion 301a, the first intermediate portion 301m, and the second pseudo-monocrystalline portion 301b are adjacent to each other in the stated order in the positive X-direction as the second direction perpendicular to the first direction. In the example in FIGs. 34 and 35, the first portion 301 includes the first pseudo-monocrystalline portion 301a, the first intermediate portion 301m, and the second pseudo-monocrystalline portion 301b.

The first pseudo-monocrystalline portion 301a and the second pseudo-monocrystalline portion 301b each include a pseudo-monocrystal. The first pseudo-monocrystalline portion 301a corresponds to a part of the first central portion 200a of the silicon ingot 2B. The second pseudo-monocrystalline portion 301b corresponds to a part of the second central portion 200b of the silicon ingot 2B. In the example in FIGs. 34 and 35, each of the first pseudo-monocrystalline portion 301a and the second pseudo-monocrystalline portion 301b is a rectangular prism including a rectangular upper surface facing in the positive Z-direction as the first direction and a rectangular lower surface facing in the negative Z-direction as the fourth direction.

The first intermediate portion 301m (also simply referred to as an intermediate portion) includes one or more pseudo-monocrystals. The first intermediate portion 301m corresponds to a part of the intermediate portion 200m of the silicon ingot 2B. In the example in FIGs. 34 and 35, the first intermediate portion 301m is a plate-like portion including an elongated rectangular upper surface facing in the positive Z-direction as the first direction and an elongated rectangular lower surface facing in the negative Z-direction as the fourth direction. Thus, a boundary (third boundary) B3 between the first pseudo-monocrystalline portion 301a and the first intermediate portion 301m and a boundary (fourth boundary) B4 between the second pseudo-monocrystalline portion 301b and the first intermediate portion 301m are, for example, rectangular. In FIGs. 34 and 35, the third boundary B3 and the fourth boundary B4 are each indicated by a thin two-dot-dash line.

In the first portion 301, a width (also referred to as a first width) W1 of the first pseudo-monocrystalline portion 301a and a width (also referred to as a second width) W2 of the second pseudo-monocrystalline portion 301b are each larger than a width (also referred to as a third width) W3 of the first intermediate portion 301m in the positive X-direction as the second direction. For example, each of the first surface 31 and the second surface 32 of the n-type silicon block 3B is a rectangular surface or a square surface measuring about 300 to 320 mm on each side. In this case, each of the first width W1 and the second width W2 is, for example, about 50 to 250 mm. The third width W3 is, for example, about 2 to 25 mm.

In the first portion 301, each of the third boundary B3 and the fourth boundary B4 includes a coincidence boundary. For example, the surface of each of the first pseudo-monocrystalline portion 301a, the second pseudo-monocrystalline portion 301b, and the first intermediate portion 301m perpendicular to the positive Z-direction as the first direction has the Miller indices of (100). In other words, for example, the crystal direction of each of the first pseudo-monocrystalline portion 301a and the second pseudo-monocrystalline portion 301b parallel to the positive Z-direction as the first direction have the Miller indices of <100>, and the crystal directions of one or more pseudo-monocrystals included in the first intermediate portion 301m parallel to the positive Z-direction as the first direction have the Miller indices of <100>. In this case, for example, the coincidence boundary includes one of a Σ5 coincidence boundary, a Σ13 coincidence boundary, a Σ17 coincidence boundary, a Σ25 coincidence boundary, or a Σ29 coincidence boundary. The n-type silicon block 3B with this structure may be obtained by, for example, growing pseudo-monocrystals through the unidirectional solidification of the silicon melt 72 from the seed crystal assembly 6 and forming a coincidence boundary above each of the boundaries between the first main seed crystal 61a and the intermediate seed crystal 61m and between the second main seed crystal 61b and the intermediate seed crystal 61m. The coincidence boundaries may reduce distortions as they form, thus reducing defects in the silicon ingot 2B. This can also reduce defects in the n-type silicon block 3B obtained by cutting off, for example, the peripheral portion 202 of the silicon ingot 2B. For example, the n-type silicon block 3B with the above structure suited to the manufacture of the silicon ingot 2B with fewer defects may have higher quality with fewer defects. The coincidence boundaries and the ratio of each type of coincidence boundary may be identified in each of the third boundary B3 and the fourth boundary B4 by, for example, EBSD.

The n-type silicon block 3B may be divided into, using a wire saw or another tool, m1 pieces (m1 is a natural number greater than or equal to 2) in the positive X-direction as the second direction and into m2 pieces (m2 is a natural number greater than or equal to 2) in the positive Y-direction as the third direction to obtain (m1 × m2) n-type silicon blocks. For example, the n-type silicon block 3B may be divided into two equal pieces in the positive X-direction and into two equal pieces in the positive Y-direction along the thin dashed lines in FIGs. 34 and 35 to obtain four n-type silicon blocks. In this case, each n-type silicon block obtained by dividing the n-type silicon block 3B may be used as the n-type silicon block 3B.

The n-type silicon block 3B described in the above example includes the first portion 301 including the two pseudo-monocrystalline portions aligned in the positive X-direction as the second direction and the intermediate portion between the two pseudo-monocrystalline portions. However, the structure is not limited to this example. The first portion 301 may include, for example, three or more pseudo-monocrystalline portions aligned in the positive X-direction as the second direction and intermediate portions each between adjacent ones of the three or more pseudo-monocrystalline portions. This structure may be achieved when, for example, the main seed crystal assembly 61B includes three or more main seed crystals aligned in the positive X-direction as the second direction and intermediate seed crystals each between adjacent ones of the three or more main seed crystals. The first portion 301 may include, for example, two or more pseudo-monocrystalline portions aligned in the positive Y-direction as the third direction and intermediate portions each between adjacent ones of the two or more pseudo-monocrystalline portions. This structure may be achieved when, for example, the main seed crystal assembly 61B includes two or more main seed crystals aligned in the positive Y-direction as the third direction and intermediate seed crystals each between adjacent ones of the two or more main seed crystals.

### N-Type Silicon Substrate

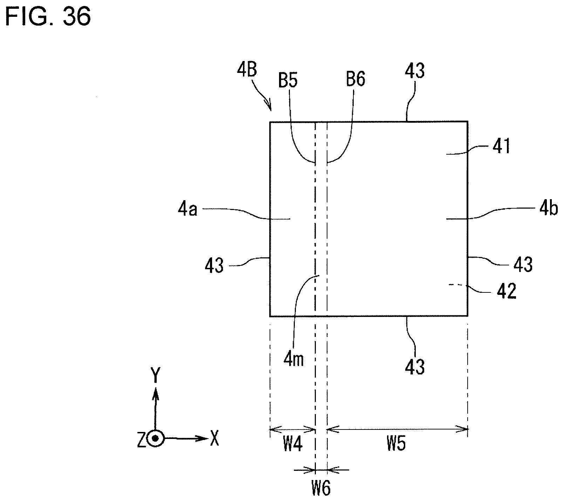

The n-type silicon substrate 4B according to the third embodiment with an example structure will be described with reference to FIG. 36. The n-type silicon substrate 4B may be obtained by, for example, dividing the first portion 301 of the n-type silicon block 3B into two equal pieces in the positive X-direction and into two equal pieces in the positive Y-direction, and then slicing the resultant pieces along an XY plane.

As illustrated in the example in FIG. 36, the n-type silicon substrate 4B includes a fourth surface 41, a fifth surface 42, and sixth surfaces 43 in the same manner as the n-type silicon substrate 4 according to the first embodiment.

The n-type silicon substrate 4B includes a third pseudo-monocrystalline portion 4a, a second intermediate portion 4m, and a fourth pseudo-monocrystalline portion 4b. The third pseudo-monocrystalline portion 4a, the second intermediate portion 4m, and the fourth pseudo-monocrystalline portion 4b are adjacent to each other in the stated order in the positive X-direction as the second direction perpendicular to the first direction. In the example in FIG. 36, the n-type silicon substrate 4B includes the third pseudo-monocrystalline portion 4a, the second intermediate portion 4m, and the fourth pseudo-monocrystalline portion 4b.

Each of the third pseudo-monocrystalline portion 4a and the fourth pseudo-monocrystalline portion 4b includes a pseudo-monocrystal. The third pseudo-monocrystalline portion 4a corresponds to a part of the first pseudo-monocrystalline portion 301a of the n-type silicon block 3B. The fourth pseudo-monocrystalline portion 4b corresponds to a part of the second pseudo-monocrystalline portion 301b of the n-type silicon block 3B. In the example in FIG. 36, each of the third pseudo-monocrystalline portion 4a and the fourth pseudo-monocrystalline portion 4b is a plate-like portion including a rectangular upper surface facing in the positive Z-direction as the first direction and a rectangular lower surface facing in the negative Z-direction as the fourth direction.

The second intermediate portion 4m includes one or more pseudo-monocrystals. The second intermediate portion 4m corresponds to a part of the first intermediate portion 301m of the n-type silicon block 3B. In the example in FIG. 36, the second intermediate portion 4m is an elongated plate-like portion including an elongated rectangular upper surface facing in the positive Z-direction as the first direction and an elongated rectangular lower surface facing in the negative Z-direction as the fourth direction. Thus, a boundary (fifth boundary) B5 between the third pseudo-monocrystalline portion 4a and the second intermediate portion 4m and a boundary (sixth boundary) B6 between the fourth pseudo-monocrystalline portion 4b and the second intermediate portion 4m are, for example, elongated and rectangular. In FIG. 36, each of the fifth boundary B5 and the sixth boundary B6 is indicated by a thin two-dot-dash line.

In the n-type silicon substrate 4B, a width (also referred to as a fourth width) W4 of the third pseudo-monocrystalline portion 4a and a width (also referred to as a fifth width) W5 of the fourth pseudo-monocrystalline portion 4b are each larger than a width (also referred to as a sixth width) W6 of the second intermediate portion 4m in the positive X-direction as the second direction. For example, each of the fourth surface 41 and the fifth surface 42 of the n-type silicon substrate 4B is a square surface measuring about 150 mm on each side. In this case, each of the fourth width W4 and the fifth width W5 is, for example, about 50 to 100 mm. The sixth width W6 is, for example, about 2 to 25 mm.

In the n-type silicon substrate 4B, each of the fifth boundary B5 and the sixth boundary B6 includes a coincidence boundary. For example, the surface of each of the third pseudo-monocrystalline portion 4a, the fourth pseudo-monocrystalline portion 4b, and the second intermediate portion 4m perpendicular to the positive Z-direction as the first direction has the Miller indices of (100). In other words, for example, the crystal direction of each of the third pseudo-monocrystalline portion 4a and the fourth pseudo-monocrystalline portion 4b parallel to the positive Z-direction as the first direction have the Miller indices of <100>, and the crystal directions of one or more pseudo-monocrystals included in the second intermediate portion 4m parallel to the positive Z-direction as the first direction have the Miller indices of <100>. In this case, for example, the coincidence boundary includes one of a Σ5 coincidence boundary, a Σ13 coincidence boundary, a Σ17 coincidence boundary, a Σ25 coincidence boundary, or a Σ29 coincidence boundary. The n-type silicon substrate 4B with this structure may be obtained by, for example, growing pseudo-monocrystals through the unidirectional solidification of the silicon melt 72 from the seed crystal assembly 6 and forming a coincidence boundary above each of the boundaries between the first main seed crystal 61a and the intermediate seed crystal 61m and between the second main seed crystal 61b and the intermediate seed crystal 61m. The coincidence boundaries may reduce distortions as they form, thus reducing defects in the silicon ingot 2B. The n-type silicon substrate 4B sliced from the n-type silicon block 3B obtained by cutting off, for example, the peripheral portion 202 of the silicon ingot 2B may also have fewer defects. For example, the n-type silicon substrate 4B with the above structure suited to the manufacture of the n-type silicon ingot 2B with fewer defects may have higher quality with fewer defects. The coincidence boundaries and the ratio of each type of coincidence boundary may be identified in each of the fifth boundary B5 and the sixth boundary B6 by, for example, EBSD.

The n-type silicon substrate 4B described in the example described above includes the two pseudo-monocrystalline portions aligned in the positive X-direction as the second direction and the intermediate portion between the two pseudo-monocrystalline portions. However, the structure is not limited to this example. The n-type silicon substrate 4B may include, for example, three or more pseudo-monocrystalline portions aligned in the positive X-direction as the second direction and intermediate portions each between adjacent ones of the three or more pseudo-monocrystalline portions. This structure may be achieved when, for example, the main seed crystal assembly 61B includes three or more main seed crystals aligned in the positive X-direction as the second direction and intermediate seed crystals each between adjacent ones of the three or more main seed crystals. The n-type silicon substrate 4B may include, for example, two or more pseudo-monocrystalline portions and intermediate portions each between adjacent ones of the two or more pseudo-monocrystalline portions in the positive Y-direction as the third direction. This structure may be achieved when, for example, the main seed crystal assembly 61B includes two or more main seed crystals aligned in the positive Y-direction as the third direction and intermediate seed crystals each between adjacent ones of the two or more main seed crystals.

### 3. Other Embodiments

In each of the above embodiments, the manufacturing apparatus 1 may eliminate the upper unit 13. In this case, in step Sp23, multiple silicon lumps 71 are, for example, placed on the silicon seed crystal assembly 6 placed on the bottom 141b of the mold 141. In this process, the silicon lumps 71 are mixed with a group 15 element as the n-type dopant and with a group 13 element as the p-type dopant. In another example, in step Sp4, the silicon lumps 71 in the mold 141 may be heated and melted. The resultant silicon melt 72 may cover the upper surface of the seed crystal assembly 6 placed on the bottom 141b of the mold 141.

Although the n-type silicon blocks 3, 3A, and 3B and the n-type silicon substrates 4 and 4B have been described in detail, the above structures are illustrative in all respects, and the disclosure is not limited to the above structures. The above embodiments may be combined in any manner unless any contradiction arises. Many variations not specifically described above may be implemented without departing from the scope of the disclosure.

### REFERENCE SIGNS

3, 3A, 3B n-type silicon block
301 first portion
301a first pseudo-monocrystalline portion
301b second pseudo-monocrystalline portion
301m first intermediate portion
31 first surface
32 second surface
33 third surface
4, 4B n-type silicon substrate
41 fourth surface
42 fifth surface
43 sixth surface
4a third pseudo-monocrystalline portion
4b fourth pseudo-monocrystalline portion
4m second intermediate portion
B3 third boundary
B4 fourth boundary
B5 fifth boundary
B6 sixth boundary
W1 first width
W2 second width
W3 third width
W4 fourth width
W5 fifth width
W6 sixth width

## Claims

1. An n-type silicon block, comprising:
a donor including a group 15 element;
an acceptor including a group 13 element;
carbon; and
oxygen,
wherein the n-type silicon block includes more atoms of the donor than atoms of the acceptor per unit volume,
the donor has a greater segregation coefficient in silicon than the acceptor, and
the n-type silicon block includes a first portion including more carbon atoms than oxygen atoms per unit volume.

2. The n-type silicon block according to claim 1, wherein
the donor comprises at least one element selected from the group consisting of phosphorus, arsenic, and antimony, and
the acceptor comprises at least one element selected from the group consisting of aluminum, gallium, and indium.

3. The n-type silicon block according to claim 1 or claim 2, wherein
the first portion includes a monocrystalline portion.

4. The n-type silicon block according to claim 1 or claim 2, further comprising:
a first surface;
a second surface opposite to the first surface; and
a third surface connecting the first surface and the second surface and extending in a first direction,
wherein the first portion includes a first pseudo-monocrystalline portion, a first intermediate portion including one or more pseudo-monocrystals, and a second pseudo-monocrystalline portion located adjacent to each other in a second direction perpendicular to the first direction in an order of the first pseudo-monocrystalline portion, the first intermediate portion, and the second pseudo-monocrystalline portion, the first pseudo-monocrystalline portion has a first width larger than a third width of the first intermediate portion in the second direction, and the second pseudo-monocrystalline portion has a second width larger than the third width in the second direction, and
a boundary between the first pseudo-monocrystalline portion and the first intermediate portion includes a coincidence boundary, and a boundary between the second pseudo-monocrystalline portion and the first intermediate portion includes a coincidence boundary.

5. An n-type silicon substrate, comprising:
a donor including a group 15 element;
an acceptor including a group 13 element;
carbon; and
oxygen,
wherein the n-type silicon substrate includes more atoms of the donor than atoms of the acceptor per unit volume,
the donor has a greater segregation coefficient in silicon than the acceptor, and
the n-type silicon substrate includes more carbon atoms than oxygen atoms per unit volume.

6. The n-type silicon substrate according to claim 5, wherein
the donor comprises at least one element selected from the group consisting of phosphorus, arsenic, and antimony, and
the acceptor comprises at least one element selected from the group consisting of aluminum, gallium, and indium.

7. The n-type silicon substrate according to claim 5 or claim 6, further comprising:
a monocrystalline portion.

8. The n-type silicon substrate according to claim 5 or claim 6, further comprising:
a fourth surface;
a fifth surface opposite to the fourth surface in a first direction;
a sixth surface connecting the fourth surface and the fifth surface;
a third pseudo-monocrystalline portion;
a second intermediate portion including one or more pseudo-monocrystals; and
a fourth pseudo-monocrystalline portion,
wherein the third pseudo-monocrystalline portion, the second intermediate portion, and the fourth pseudo-monocrystalline portion are located adjacent to each other in a second direction perpendicular to the first direction in an order of the third pseudo-monocrystalline portion, the second intermediate portion, and the fourth pseudo-monocrystalline portion,
the third pseudo-monocrystalline portion has a fourth width larger than a sixth width of the second intermediate portion in the second direction, and the fourth pseudo-monocrystalline portion has a fifth width larger than the sixth width in the second direction, and
a boundary between the third pseudo-monocrystalline portion and the second intermediate portion includes a coincidence boundary, and a boundary between the fourth pseudo-monocrystalline portion and the second intermediate portion includes a coincidence boundary.
